# EUROPÄISCHE PATENTSCHRIFT

(11) **EP 2 369 353 B1**
(45) Veröffentlichungstag und Bekanntmachung des Hinweises auf die Patenterteilung: **21.05.2014**
(21) Anmeldenummer: 11157890.2
(22) Anmeldetag: 11.03.2011
(51) Int. Cl.: G01R 15/20, G01R 22/06, G01R 1/04, G01R 1/20

(54) **Kontaktlose Strommessvorrichtung und Verbraucherenergiemesssystem**
Contact-free current measuring device and consumer energy meter
Dispositif de mesure de courant sans contact et système de mesure d'énergie de consommateurs

(30) Priorität: 12.03.2010 DE 102010015940
(43) Veröffentlichungstag der Anmeldung: 28.09.2011
(73) Patentinhaber: EnBW Energie Baden-Württemberg AG, 76131 Karlsruhe (DE)
(72) Erfinder: Niemöller, Christopher, 31812 Bad Pyrmont (DE)
(74) Vertreter: Kaufmann, Ursula Josefine

(56) Entgegenhaltungen:
- WO-A1-92/15889
- WO-A1-96/22541
- DE-A1-102005 025 541
- US-A- 6 081 109
- US-A1- 2009 079 416

## Beschreibung

### Stand der Technik

Die Erfindung geht aus von einer kontaktlosen Strommessvorrichtung für die Bestimmung einer elektrischen Verbrauchsenergie eines mittels eines Verbrauchersteckers an ein elektrisches Wechsel- oder Drehstromenergieversorgungsnetz anschließbaren Verbrauchers, die zumindest eine Magnetfeldsonde zur Messung der Stärke eines Magnetfelds einer stromdurchflossenen Verbraucherleitung, eine Auswerteeinrichtung im elektrischen Kontakt mit der Magnetfeldsonde zur Bestimmung des vom Verbraucher aufgenommenen elektrischen Stroms, eine Kommunikationseinrichtung zur drahtlosen Weitergabe zumindest eines bestimmten Stromwerts an zumindest eine Verbraucherenergieauswertevorrichtung und einen elektrischen Energiespeicher, insbesondere Batterie, Akkumulator oder Kondensator, zur elektrischen Energieversorgung zumindest der Auswerteeinrichtung und der Kommunikationseinrichtung umfasst, wobei die Strommessvorrichtung galvanisch vom Energieversorgungsnetz getrennt ist.

Vor dem Hintergrund der Erfindung dienen Strommessvorrichtungen zur Bestimmung des von einem Verbraucher aufgenommenen Stroms, um hieraus die elektrische Leistung und den elektrischen Energieverbrauch eines Verbrauchers ableiten zu können. Eine solche Strommessvorrichtung wird häufig als Submeter (Zwischenzähler) bezeichnet und dient dazu, einzelne Stromverbraucher oder Stromkreise gezielt auf ihren Stromverbrauch hin überprüfen zu können, um damit den Energieverbrauch analysieren und kontrollieren zu können. Diesbezüglich existieren auf dem Markt eine große Anzahl verschiedener Systeme, die dazu dienen, den Energieverbrauch von steckeranschließbaren Verbrauchern an einem Energieversorgungsnetz messen zu können. Zumeist werden die Verbrauchsdaten lokal an der Strommessvorrichtung angezeigt. Darüber hinaus gibt es Strommesssysteme, die ihre Messdaten beispielsweise drahtgebunden, insbesondere über eine Power-Line-Kommunikation (PLC) über die Energieversorgungsleitungen, oder drahtlos, insbesondere per Funk, an eine zentrale Verbraucherenergieauswertevorrichtung übertragen.

Im betrachteten technischen Gebiet wird der Einsatz dezentraler Strommessvorrichtungen in einem Verbraucherenergiemesssystem zur Realisierung einer "Smart-Metering"-Systems betrachtet, die dem Versorgungsnetzkunden und ebenfalls dem Versorgungsnetzbetreiber ein Mittel zur Verfügung stellen, die den Forderungen des Gesetzes über die Elektrizitäts- und Gasversorgung Rechnung trägt. Hiernach wird der Einsatz von intelligenten Zählern und Smart-Metering-Systemen gefordert, die den tatsächlichen Energieverbrauch und die tatsächliche Nutzungszeit anzeigen können, wobei unterjährige Verbrauchsinformationen einen Anreiz zur Senkung der Stromkosten bieten sollen, eine monatliche, viertel-oder halbjährliche Energiekostenabrechnung erstellt werden kann, last- und verbrauchsabhängige Tarife angeboten werden können und die Transparenz und Analyse des eigenen Energieverbrauchs erhöht werden soll. Hierzu wurde das Konzept des Open-Metering-Systems entwickelt, bei dem der Einsatz sowohl von dezentralen Verbraucherenergieauswertevorrichtungen, insbesondere intelligenten Zählern mit eingebauter Fernkommunikationsmöglichkeit, als auch zentrale Verbraucherenergieauswertevorrichtungen, die die Informationen untergeordneter Zähler gleichberechtigt sammeln und auswerten, ausgebaut werden soll.

Zur Messung des Stroms kommen grundsätzlich zwei Verfahren zum Einsatz, zum einen ein direktes Strommessverfahren, bei der ein Spannungsabfall über einen bekannten Messwiderstand gemessen und somit in eine Stromgröße umgerechnet werden kann, wobei sich der Nachteil ergibt, dass der gesamte Verbraucherstrom über einen vordefinierten (kleinen) Messwiderstand geführt werden muss, und somit zu ohmschen Verlusten führt, wobei der Messwiderstand für hohe Ströme ausgelegt sein muss. Zum anderen eine berührungslose Strommessung, bei der die Stärke des Leitermagnetfelds, das von dem Verbraucherstrom erzeugt wird und das proportional zum Strom variiert, mittels einer Magnetfeldsonde gemessen wird. Die aus dem Stand der Technik bekannte Strommessvorrichtungen sind in vielen Fällen in einem Zwischensteckgehäuse, das über eine eigene Steckeinrichtung und eine Kupplungseinrichtung verfügt, eingebettet und entsprechend groß und klobig, so dass deren Einsatz oftmals mit technischen Schwierigkeiten verbunden ist (Steckerzwischenraum zu klein, schlechte Kontaktverbindung, unschönes Aussehen) und sind Standalone-Lösungen, die mit keiner Verbrauchsenergieauswertevorrichtung kommunizieren können. In der Regel weisen bekannte Strommessvorrichtungen einen Eigenenergiebedarf auf, der zwischen 2 bis 10 Watt liegt, wobei die Messenergie entweder vom Energieversorgungsnetz abgezweigt oder über eine interne Energiequelle, beispielsweise Batterie oder Akku, zur Verfügung gestellt wird. Durch den nicht zu vernachlässigenden Eigenenergieverbrauch werden erzielbare Energieeinsparungen für den Verbraucher oftmals zunichte gemacht. Des Weiteren sind gattungsgemäße Strommessvorrichtungen relativ teuer, kosten zwischen 30 bis 120 Euro, so dass solche Strommessvorrichtungen in der Regel nicht in großer Zahl an vielen verschiedenen Verbrauchern in einem Haushalt angeschlossen werden, sondern nur vereinzelt an kritischen Verbrauchern, wie beispielsweise Kühlschrank oder Waschmaschine, angebracht werden. Jedoch interessiert einen Versorgungsnetzkunden die Aufnahme der elektrischen Verbrauchsleistung vieler verschiedener, teilweise leistungsschwacher Verbraucher, um deren Energieverbrauch mit dem Ziel überwachen und analysieren zu können, den Stromverbrauch durch eine intelligente Verwendung der elektrischen Verbraucher senken zu können.

In der DE 10 2005 025 541 A1 wird eine Strommessvorrichtung zur Messung einer Verbraucherenergie vorgeschlagen, die in einer Steckdose integriert ist, und die Mittel zur Stromerkennung und Auswertung umfasst. Hierzu kann die Strommessvorrichtung über eine Magnetfeldsonde den aufgenommenen Strom eines Verbrauchers messen, und beispielsweise über eine drahtlose Kommunikationseinrichtung diese Messwerte an ein Anzeigesystem übermitteln. Die Strommessvorrichtung dient als Stromüberwachungssteckdose dazu, einen aktuellen Zustand eines elektrischen Verbrauchers anzuzeigen, wobei ein Meldesignal abgegeben wird, sobald ein detektierter Strom einen vorgegebenen Schwellwert überschreitet. Allerdings ist die Strommessvorrichtung in einer Netzsteckdose integriert, und somit nicht von einem Versorgungsnetzkunden einfach zu installieren, und durch Verbindung mit einer Festinstallation nicht einfach austauschbar. Der Verbraucher ist nicht in der Lage, den Stromverbrauch beliebig vieler Verbraucher mit niedrigen Kosten überwachen zu können.

In der US 2009/079416 A1 wird eine Strommessvorrichtung beschrieben, die zwischen einem Stecker eines elektrischen Verbrauchers und einer Steckdose zwischensteckbar ist. Ein Stromsensor bestimmt einen Stromfluss durch eine stromdurchflossene Stromleitung. Eine Energieversorgung der Messvorrichtung basiert entweder auf einer auswechselbaren Batterie oder auf einer galvanischen Kontaktierung der Verbraucherstromleitung.

Die WO 96/22541 A offenbart einen Stromdefektsensor, der an eine Hoch- oder Niederspannungsleitung eines öffentlichen Stromverteilernetzes anschließbar ist. Der Stromdefektsensor umfasst einen Funktransmitter, um durch eine Strommessspule bestimmte Strommesswerte, die einen kurz- oder langfristigen Stromausfall, Stromüberlastung oder einen Kurzschlussfall indizieren, an eine Energieversorgungsleitstelle weiterzugeben. Zur Stromversorgung der Sensorschaltung sind Kondensatoren vorgesehen, die entweder über ein Photovoltaikmodul oder über einen separaten Stromtransformator aufgeladen werden.

Aufgabe der Erfindung ist es, eine Strommessvorrichtung für die Bestimmung einer elektrischen Verbrauchsenergie eines mittels eines Verbrauchssteckers an ein elektrisches Wechsel- oder Drehstromenergieversorgungsnetz anschließbaren Verbrauchers vorzuschlagen, um den elektrischen Verbraucher gezielt auf seinen Stromverbrauch analysieren zu können, wobei die Strommessvorrichtung günstig herstellbar sein soll und weniger als 10 Euro kosten soll, vom Versorgungsnetzkunden einfach zu installieren sein soll und platzsparend ausgestaltet sein muss, so dass sie an jede Steckdose angeschlossen werden kann. Eine Weitere Aufgabe der Strommessvorrichtung ist, die Daten an eine zentrale Verbraucherenergieauswertevorrichtung drahtlos zu übermitteln, keine optische oder elektrische Beeinträchtigung des Verbraucheranschlusses an das Energienetz mit sich zu bringen, und sich in eine bestehende Infrastruktur, insbesondere in Verbindung mit einem intelligenten Zähler, integrieren zu lassen.

Intelligente Zähler werden in diesem Zusammenhang als elektronische Zähler angesehen, die über eingebaute Zusatzfunktionen verfügen, oder die nachträgliche Module umfassen können, um gemessene Zählerzustände vom Energieversorgungsunternehmen über die Ferne auslesen zu können. Zur Datenfernübertragung solcher Zählerzustände werden insbesondere drahtlose Funknetzdienste, wie GSM, GPRS, W-LAN, WiMAX oder ähnliches, oder drahtgebundene Kommunikationsmöglichkeiten, wie PSTN, LAN oder PLC, verwendet. Hierdurch kommunizieren intelligente Zähler mit einem Netzwerk zur Übermittlung von E-nergieverbrauchswerten, wobei Versorgungsnetzbetreiber aber auch Versorgungsnetzkunden über dieses Netzwerk Zugriff auf die gemessenen Energieverbrauchswerte nehmen können. Des Weiteren können intelligente Zähler beispielsweise den aktuellen Stromtarif ausweisen, die tatsächlich vorherrschende Netzspannung messen, und eine Historie von Verbrauchsdaten speichern. Eine Kombination der Messwerte einer Strommessvorrichtung mit den Zusatzfunktionalitäten eines intelligenten Zählers kann dem Versorgungsnetzkunden oder dem Versorgungsnetzbetreiber detaillierte Auskunft über die Quellen eines hohen oder niedrigen Energieverbrauchs geben, und ihm eine Analysemöglichkeit zur Verfügung stellen, um effizient Energie einsparen zu können.

### Offenbarung der Erfindung

Die Erfindung geht aus von einer kontaktlosen Strommessvorrichtung für die Bestimmung einer elektrischen Verbrauchsenergie eines mittels eines Verbrauchsteckers an ein elektrisches Wechsel- oder Drehstromenergieversorgungsnetz anschließbaren Verbrauchers. Hierzu umfasst die Strommessvorrichtung zumindest eine Magnetfeldsonde zur Messung der Stärke eines Magnetfelds einer stromdurchflossenen Verbraucherleitung und eine Auswerteeinrichtung im elektrischen Kontakt mit der Magnetfeldsonde zur Bestimmung des vom Verbraucher aufgenommenen elektrischen Stroms. Des Weiteren umfasst die Strommessvorrichtung eine Kommunikationseinrichtung zur drahtlosen Weitergabe zumindest des bestimmten Stromwerts an zumindest eine Verbraucherenergieauswertevorrichtung und einen elektrischen Energiespeicher, insbesondere Batterie, Akkumulator oder Kondensator, zur elektrischen Energieversorgung zumindest der Auswerteeinrichtung und der Kommunikationseinrichtung, wobei die Strommessvorrichtung galvanisch vom Energieversorgungsnetz getrennt ist.

Es wird vorgeschlagen, dass die Strommessvorrichtung so ausgebildet ist, dass zumindest die Magnetfeldsonde in einem Zwischensteckgehäuse angeordnet ist, das dazu geeignet ist, in einer Steckverbindung zwischen Verbraucherstecker und Anschlussdose/Anschlusskupplung des Energieversorgungsnetzes zwischengeschaltet zu werden.

Somit wird ein kleiner Einsatz für bestehende Steckdosen oder ein Zwischenadaptereinsatz vorgeschlagen, der eine Strommessvorrichtung umfasst und beispielsweise ähnlich wie eine Kindersicherung in eine Schuko-Steckdose eingelegt werden kann, oder wie ein Zwischenadapter zwischen Steckdose und Verbraucherstecker zwischengesteckt werden kann. Das Aussehen des Zwischensteckgehäuses richtet sich nach Art der Anschlussdose/Anschlusskupplung und kann somit je nach Steckdosenart und Einsatzland variieren. Das Zwischensteckgehäuse ist so ausgeformt, dass zumindest an oder um einem stromführenden Leiter zwischen Anschlussdose/Anschlusskupplung und Verbraucherstecker eine Magnetfeldsonde angeordnet ist, die das Leitermagnetfeld messen kann, wobei der das Magnetfeld erzeugende Verbraucherstrom durch eine Auswerteeinrichtung, insbesondere Auswerteelektronik, die beispielsweise einen Mikroprozessor umfassen kann, ausgewertet und mittels einer drahtlosen Kommunikationseinrichtung, insbesondere Funkschnittstelle, nach außen an eine entfernte Verbraucherenergieauswertevorrichtung weitergegeben wird. Es ist denkbar, dass die Auswerteeinrichtung auf Basis des gemessenen Stroms und unter Kenntnis der Netzspannung - als vorgegebener Wert, z.B. 240V für Wechselstrom, 300V für Drehstrom oder unter Berücksichtigung eines gemessenen Spannungswertes, der von einem intelligenten Zähler übermittelt wird, die Leistung des Verbrauchers bestimmt. Umfasst die Auswerteeinrichtung des weiteren einen Zeitgeber, so kann der elektrische Energieverbrauch des Verbrauchers bestimmt werden. Die Messdaten können beispielsweise regelmäßig nach einem festen periodischen Zeitintervall oder bei Bedarf, beispielsweise bei Änderung der Stromstärke, übertragen werden. Hierzu können alle Bauteile der Auswerteeinrichtung, der Kommunikationseinrichtung, des Energiespeichers und der Magnetfeldsonde auf einer dünnen Leiterplatte kompakt angeordnet werden oder in einer gedruckten Form ausgeführt sein. Das Zwischensteckgehäuse lässt sich somit in eine Netzanschlussdose einlegen, eingießen oder einkleben. Herstellern von Steckdosen kann darüber hinaus die Möglichkeit gegeben werden, die Strommessvorrichtung mit Zwischensteckgehäuse in ein Gehäuse einer Steckdose einzugießen, zu integrieren oder durch Vorsehen von Schnappelemente für die Halterung einer Strommessvorrichtung vorzubereiten. Wesentlich ist, dass kein elektrischer Kontakt zwischen Strommessvorrichtung und den Kontakten der Steckdose oder des Verbrauchersteckers hergestellt wird, so dass eine galvanische Trennung des Energieversorgungsnetzes von der Strommessvorrichtung besteht. Die erfindungsgemäße Strommessvorrichtung kann als Submeter dazu dienen, einzelne Verbraucher oder Stromkreise gezielt auf den Stromverbrauch zu überwachen, so dass der Versorgungsnetzkunde den Verbrauch seiner Elektrogeräte besser verstehen und kontrollieren kann. Insbesondere ist angedacht, dass die Strommessvorrichtung als "Giveaway" kostenlos oder gegen ein geringes Entgelt von Energieversorgungsnetzbetreibern an Versorgungsnetzkunden abgegeben werden kann, die diese zur Überwachung ihres Stromverbrauchs an den einzelnen Verbraucher problemlos, ohne technische Hilfsmittel, und ohne Fachkenntnis zwischenschalten können, um ihren Stromverbrauch transparent zu machen. Besonders vorteilhaft kann die Strommessvorrichtung in ein intelligentes System eingebunden sein, wie es in der WO 08122408 A2 beschrieben ist, das über einen Push-Dienst z.B. Verbrauchsdaten an einen Anbieter übermitteln kann.

Erfindungsgemäß wird vorgeschlagen, dass die Magnetfeldsonde eine Induktivitätsspule ist, und dass der elektrische Energiespeicher ein wiederaufladbarer elektrischer Energiespeicher, insbesondere ein Akkumulator oder Kondensator, ist. Des Weiteren wird vorgeschlagen, dass zwischen Induktivitätsspule und Energiespeicher eine Gleichrichtereinrichtung geschaltet ist, so dass der wiederaufladbare Energiespeicher mittels der induzierten Spannung in der Induktivitätsspule aufladbar ist. Somit wird eine autarke Strommessvorrichtung bereitgestellt, deren interner Energiespeicher zum Betrieb der Auswerteeinrichtung und Kommunikationseinrichtung aus der magnetischen Energie, die von den Induktivitätsspulen erfasst wird, be-zogen wird. Ein stromdurchflossener Leiter entwickelt ein Magnetfeld, wobei im Falle eines Wechselmagnetfelds in den Induktivitätsspulen eine Spannung induziert wird, die proportional zur Stärke des Magnetfelds ist. Insbesondere bei hohen Strömen, also bei leistungsstarken Verbrauchern kann die induzierte Spannung dazu genutzt werden, einen Energiespeicher aufzuladen, insbesondere in Zeitspannen, in denen Auswerteeinrichtung und Kommunikationseinrichtung inaktive sind, beispielsweise in einer Zeitspanne zwischen zwei Anforderungen von Strommesswerten oder in Zeiten, in denen der Stromverbrauch gleich bleibt, so dass Auswerteeinrichtung und Kommunikationseinrichtung keine Änderungen des Stromverlaufs melden müssen. Die im Magnetfeld gespeicherte Energie wird in dieser Zeit dazu genutzt, den Energiespeicher aufzuladen, um Energie für den Betrieb der Strommessvorrichtung über eine lange Zeit aufzusammeln. Somit kann die Strommessvorrichtung mit einem sehr geringen Energiebedarf autark und wartungsfrei eine praktisch unbegrenzte Lebensdauer erreichen, und ist somit wartungsfrei und langlebig. Die Gleichrichtereinrichtung dient dazu, die in der Induktivitätsspule induzierte Wechselspannung in Gleichspannung umzuwandeln, und kann hierzu typische Gleichrichterbauteile wie Dioden und einen Kondensator, insbesondere in einer Brückengleichrichterschaltung umfassen. Der Kondensator dient zur Glättung der Spannung und kann bevorzugt selbst als Energiespeicher genutzt werden.

Die Induktivitätsspule kann beliebig ausgeführt sein, bevorzugt ist sie spiral- oder rechteckförmig im Bereich eines Oberflächenlängsabschnitts eines stromführenden Leiters der Verbraucherzuleitung oder im Zwischenraum zwischen zwei Leitern gewickelt, allerdings sind andere Bauformen denkbar. In einer weiteren Ausführung kann die Induktivitätsspule als parallel zur Verbraucherleitung geführte Leitung ausgelegt sein. Wichtig ist allerdings, dass die Induktivitätsspule eine Fläche umgrenzt, die vom Magnetfeld der Verbraucherleitung durchflutbar ist. Hierzu kann es vorteilhaft sein, das magnetleitende Elemente wie Eisen oder ähnliches zur Führung und Bündelung des Leitermagnetfelds an der Verbraucherleitung bzw. zwischen zwei oder mehreren Verbraucherleitungen vorgesehen sind, und diese von der Induktivitätsspule umschlungen werden.

Gemäß einer vorteilhaften Ausgestaltung der Strommessvorrichtung kann zwischen Induktivitätsspule und wiederaufladbarem Energiespeicher eine Spannungswandlungseinrichtung zur Anpassung der induzierten Spannung der Induktivitätsspule an eine Ladespannung zur Aufladung des wiederaufladbaren elektrischen Energiespeichers geschaltet sein. Die Spannungswandlereinrichtung kann die induzierte Spannung der Induktivätsspule an eine erforderliche Ladespannung und einen benötigten Ladestrom zur Aufladung des Energiespeichers anpassen und sowohl passive elektrische Bauteile wie Transformator oder ähnliches als auch aktive Bauteile wie integrierte Schaltkreise wie Laderegler-IC, Pegelanpassungs-IC oder vergleichbares umfassen. Hierbei ist denkbar, dass als Spannungswandlereinrichtung ein Laderegler mit oder ohne Pegelanpassung eingesetzt werden kann, der als integriertes Bauteil ausgeführt sein kann. Die Spannungswandlereinrichtung kann sowohl vor (d.h. im Wechselspannungsbereich) als auch hinter einem Gleichrichtereinrichtung (im Gleichspannungsbereich) geschaltet sein, bevorzugt ist diese von der Gleichrichtereinrichtung umfasst..

Nach einer weiteren vorteilhaften Ausgestaltung der Strommessvorrichtung ist zwischen Energiespeicher und Auswerteeinrichtung eine Spannungswandlungseinrichtung zur Anpassung der Ausgangsspannung des Energiespeichers an die Versorgungsspannung der Auswerteeinrichtung geschaltet. Die Zwischenschaltung einer Spannungswandlungseinrichtung zwischen Energiespeicher und Auswerteeinrichtung eröffnet die Möglichkeit, dass der Energiespeicher eine Spannung zur Verfügung stellt, die von der Betriebsspannung von Auswerteeinrichtung und Kommunikationseinrichtung abweicht. Zur Anpassung der Spannung des Energiespeichers an die Betriebsspannung der Auswerteeinrichtung und Kommunikationseinrichtung kann eine Spannungswandlungseinrichtung, beispielsweise ein Hochsetzsteller oder ein Tiefsetzsteller, dienen, der es ermöglicht, kleine Spannungen in größere Spannungen oder umgekehrt umzuwandeln. Somit kann insbesondere ein wiederaufladbarer Energiespeichers, der durch die induzierte Spannung in der Induktivitätsspule geladen wird, eingesetzt werden, der eine geringe Ausgangsspannung, beispielsweise 0.5 bis 2 Volt, zur Verfügung stellt, die mittels der Spannungswandlungseinrichtung auf eine Betriebsspannung von 2,8 bis 5,5 Volt gewandelt wird, um damit Auswerteeinrichtung und Kommunikationseinrichtung zu betreiben. Hierzu umfasst einer solcher Hochsetzsteller oder Tiefsetzsteller beispielsweise eine Takteinrichtung, ein schnelles Schaltelement, sowie einen Kondensator und eine Spule, um Spannungen anzuheben bzw. abzusenken. Durch Zwischenschaltung einer Spannungswandlungseinrichtung wird ein hoher Freiheitsgrad bei der Auswahl von Energiespeicher und geringe Spannungsanforderungen an Auswerteeinrichtung /Kommunikationseinrichtung geschaffen, so dass insbesondere kostengünstige, energieeffiziente und miniaturisierte Bauteile zur Realisierung der Strommessvorrichtung verwendet werden können.

Gemäß einer günstigen Weiterentwicklung ist die gesamte Strommessvorrichtung in dem Zwischensteckgehäuse umfasst, d.h. Magnetfeldsonde, Auswerteeinrichtung, Kommunikationseinrichtung und elektrischer Energiespeicher sind in dem Zwischengehäuse integriert. Durch Integration aller Bauteile im Zwischensteckgehäuse, wobei die Bauteile beispielsweise als gedruckte Leiterplatte, beispielsweise in Dünnfilm- oder Dickschichttechnik, auf einem einzigen PCB angeordnet sein können, kann eine kompakte, miniaturisierte Bauform erreicht werden, wobei das Zwischensteckgehäuse entweder als Zwischensteckadapter mit eigenen Steckkontakten und eigener Anschlusskupplung ausgestaltet sein kann, oder als Durchsteckgehäuse, das über Öffnungen verfügt, durch die die Kontakte eines Verbrauchersteckers durchgesteckt werden können, um diese Kontakte des weiteren in eine Anschlussdose/Anschlusskupplung einzustecken, so dass das Zwischensteckgehäuse die Form ähnlich einer einlegbaren Kindersicherung in eine Schukosteckdose besitzt. Alternativ hierzu ist denkbar, dass lediglich die Magnetfeldsonde im Zwischensteckgehäuse integriert ist, und die übrigen Bauteile in einem externen Gehäuse untergebracht sind, das mit dem Zwischensteckgehäuse mittels Kabelverbindungen oder Anbau verbunden sein kann.

Gemäß einer weiteren vorteilhaften Ausgestaltung der Erfindung ist das Zwischensteckgehäuse in Form eines Durchsteckgehäuses zum Durchstecken von Kontaktstiften eines Verbrauchersteckers ausgelegt, dessen äußere Kontur formkomplementär zur inneren Kontur der Anschlussdose/Anschlusskupplung, insbesondere Schuko-Steckdose, Eurosteckdose, Perilex-Steckdose, CEE-Steckdose oder vergleichbare Steckdose, ausgeformt ist, und dessen Gehäusedicke d eine sichere elektrische Verbindung zwischen Stecker-Kontaktstift und Steckdosenbuchse gewährleisten kann, insbesondere die Gehäusedicke d weniger als 40% der Kontaktstiftlänge eines Verbrauchersteckers, bevorzugt weniger als 25% der Kontaktstiftlänge, beträgt. Diese Ausführungsform schlägt die Ausformung des Zwischensteckgehäuses als Durchsteckgehäuse vor, das beispielsweise in Form einer Durchsteckplatte zwischen Verbraucherstecker und Anschlussdose/Anschlusskupplung zwischengesteckt wird, wobei die Kontaktstifte des Verbrauchersteckers durch Öffnungen des Zwischensteckgehäuses durchgesteckt werden, und dann der Verbraucherstecker mit aufgestecktem Durchsteckgehäuse in dien Aufnahmetopf der Anschlussdose/Anschlusskupplung eingesteckt wird. Hierzu ist es erforderlich, dass die Außenkontur des Durchsteckgehäuses im Wesentlichen formkomplementär zur Innenkontur des Anschlusstopfes der Anschlussdose/Anschlusskupplung ausgeformt ist, wobei diese Kontur entsprechend der Ausformung der Steckdose, die spannungsspezifisch und länderspezifisch anders aufgebaut sein kann, anzupassen ist. So müssen beispielsweise spezifische Durchsteckgehäuse für eine Schuko-Steckdose oder Eurosteckdose, die über einen Phasenleiter, einen N-Leiter sowie über einen Schutzleiter verfügen (nicht im Falle einer Eurosteckdose) und für Perilex-Steckdose und CEE-Steckdose Drehstromsteckdosen, die über drei Phasen und einen N-Leiter sowie ebenfalls eine Schutzkontaktleiter verfügen, bereitgestellt werden. Dementsprechend verfügt das Durchsteckgehäuse über zwei bzw. fünf Kontaktstiftöffnungen, um die entsprechenden Kontaktstifte des Verbrauchersteckers durchführen zu können. Wesentlich ist, dass die Dicke d des Durchsteckgehäuses möglichst klein gegenüber der Länge der Kontaktstifte des Verbrauchersteckers ausfällt, um den Kontaktstiften eine ausreichende Länge für die zuverlässige elektrische Kontaktierung der Steckdosenbuchse einzuräumen. So weist ein typischer Schuko-Stecker eine Kontaktstiftlänge von 1,6 bis 2,5 cm auf, so dass das Durchsteckgehäuse eine maximale Dicke von 5 mm oder kleiner haben sollte, um einen sicheren elektrischen Kontakt zu gewährleisten. Im Falle einer Schuko-Steckdose kann die Form des Durchsteckgehäuses insbesondere dem typischen Aussehen einer einklebbaren Kindersicherungen nachempfunden sein, wobei vorteilhafterweise der Zusatznutzen einer Kindersicherung ebenfalls in dem Durchsteckgehäuse integrierbar sein kann, so dass die Durchstecköffnungen nur durch Betätigung eines Aufschiebmechanismus mittels der Kontaktstifte des Verbrauchersteckers freigelegt werden. So kann eine Ausführungsform einer Strommessvorrichtung vorteilhaft mit der Funktionalität einer Kindersicherung kombiniert werden.

Ausgehend vom vorgenannten Ausführungsbeispiel ist es weiterhin vorteilhaft, dass das Zwischensteckgehäuse zumindest ein Befestigungsmittel, insbesondere Klebemittel, Schraubenverbindungsmittel, Klemmmittel oder Ähnliches zur Befestigung des Durchsteckgehäuses an die Innenfläche des Buchsenbereichs der Anschlussdose/Anschlusskupplung umfasst. Somit wird ein Durchsteckgehäuse vorgeschlagen, das sich in den Anschlusstopf einer Anschlussdose/Anschlusskupplung einbringen lässt, und dort mittels eines Befestigungsmittels, insbesondere eines Klebemittels, wie doppelseitiges Klebeband, oder Schraubenverbindungsmittel, wie beispielsweise Zentralschraube zur Befestigung der Steckdosenabdeckung oder einem Klemmmittel, wie beispielsweise in der Außenkontur angebrachte Klemmfedern, herausfallsicher befestigt werden kann, so dass selbst bei Herausziehen des Verbrauchersteckers das Durchsteckgehäuse im Anschlusstopf verbleibt, wobei verschiedene Verbraucher an die Steckdose angeschlossen werden können, und die Strommessvorrichtung in der Anschlussdose verbleibt.

Des Weiteren ist es ausgehend von den vorgenannten beiden Ausführungsformen denkbar und vorteilhaft, dass das Zwischensteckgehäuse so ausgeformt ist, dass es bei der Herstellung einer Anschlussdosenabdeckung oder eines Kupplungsgehäuses herstellerseitig in die Innenfläche des Buchsenbereichs der Anschlussdose/Anschlusskupplung eingegossen oder sonstwie befestigt werden kann. Beispielsweise kann das Durchsteckgehäuse geeignete Riefen, Ausbuchtungen, Stege oder Vorsprünge zur besonders sicheren Halterung in einer Anschlussdose aufweisen, und das Material des Durchsteckgehäuses derart gewählt werden, dass es besonders geeignet in einer Anschlussdosenabdeckung oder einem Kupplungsgehäuse eingegossen werden kann, wobei hierdurch eine Verdickung des Anschlusstopfbodens des Buchsenbereichs der Anschlussdose/Anschlusskupplung ausbildet wird. Alternativ kann herstellerseitig die Strommessvorrichtung mittels Befestigungsmittel, beispielsweise Schraubmittel, Klemmmittel, Klebemittel oder ähnliches im Anschlusstopfboden der Anschlussdose oder der Anschlusskupplung befestigt werden, so dass bei der Herstellung einer Anschlussdosenabdeckung oder eines Kupplungsgehäuses eine Strommessvorrichtung in der Anschlussdose vorgesehen ist.

Alternativ zur vorgenannten Ausführungsform ist es denkbar, das das Zwischensteckgehäuse in Form eines Steckadapters oder einer Steckdosenleiste ausgeformt ist, wobei das Zwischensteckgehäuse zumindest eine Anschlussdose bzw. Anschlusskupplung zum Anschluss eines oder mehrerer Verbraucher und einen Verbraucherstecker zum Anschluss an eine Anschlussdose/Anschlusskupplung eines Energieversorgungsnetzes umfasst. Somit sieht diese Ausgestaltung der Strommessvorrichtung vor, dass die Strommessvorrichtung in einem Zwischensteckgehäuse angeordnet ist, das über eigene Kontaktstifte verfügt und somit in eine Anschlussdose/Anschlusskupplung eines Energieversorgungsnetzes eingesteckt werden kann, und das Gehäuse zumindest eine oder mehrere Anschlusssteckdosen bzw. Anschlusskupplungen aufweist, in die dann Verbraucherstecker gesteckt werden können. Somit kann die Strommessvorrichtung beispielsweise in einem typischen Zwischensteckgehäuse, wie es beispielsweise von Blitzschutzzwischensteckern oder Steckdosenschaltuhren bekannt ist, umfasst sein, oder kann beispielsweise in einer Steckdosenleiste mit zwei oder mehreren Steckanschlüssen für mehrere Verbraucher eingebaut sein. Somit wird vermieden, dass der Verbraucher in eine stromführenden Anschlussdose/Anschlusskupplung ein Durchsteckgehäuse einbaut, und sich der Gefahr eines elektrischen Schlags aussetzt, sondern er kann durch gefahrloses Einstecken eines Steckers des Steckadapters oder der Steckdosenleiste die Strommessvorrichtung zwischen Verbraucher und Energieversorgungsnetz zwischenstecken. Es ist weiterhin denkbar, dass die Strommessvorrichtung im Kabel der Steckdosenleiste zwischengeschaltet, beispielsweise eingegossen ist.

Ausgehend von obiger Ausführungsform ist es vorteilhaft, dass der Steckadapters oder die Steckdosenleiste eine Anzeigeneinrichtung aufweist, insbesondere eine LCD- oder LED-Anzeigeeinrichtung, die in elektrischem Kontakt mit der Auswerteeinrichtung steht und die eingerichtet ist, die Stromaufnahme des angeschlossenen Verbrauchers zumindest auf Anforderung mittels Betätigung einer Anzeigentaste anzuzeigen. Bei Ausführung des Zwischensteckgehäuses als Steckadapter oder Steckdosenleiste bleibt genügend Platz auf der Gehäuseoberfläche, um darauf eine Anzeigeneinrichtung anzuordnen, die in elektrischem Kontakt mit der Auswerteeinrichtung steht, und die zumindest die Stromaufnahme, des weiteren auch die Leistungsaufnahme und/oder den Energieverbrauch des angeschlossenen Verbrauchers innerhalb eines Zeitintervalls anzeigen kann. Vor dem Hintergrund einer energieeffizienten Strommessvorrichtung ist es vorteilhaft, dass die Anzeigeeinrichtung nur auf Anforderung beispielsweise durch Betätigung einer Anzeigentaste aktiviert wird und die gemessenen Werte nur zeitweise darstellt. Somit kann eine dezentrale Information an der Strommessvorrichtung selbst bereitgestellt werden, um den Versorgungsnetzkunden über den aktuellen Stromverbrauch eines angeschlossenen Verbrauchers zu informieren.

Gemäß eines weiteren Ausführungsbeispiels der vorgenannten Ausführungsform der Strommessvorrichtung mit Zwischensteckgehäuse in Form eines Steckadapters oder einer Steckdosenleiste ist es vorteilhaft, dass das Gehäuse des Steckadapters oder der Steckdosenleiste zumindest eine Anschlusseinrichtung in elektrischem Kontakt mit der Auswerte- und/oder Kommunikationseinrichtung zum Anschluss weiterer Einrichtungen, insbesondere einer externen Anzeigeeinrichtung, eine Funkeinrichtung zur Erhöhung der Sendereichweite der Kommunikationseinrichtung, eine Abschalt- oder Warneinrichtung zur Abschaltung des Verbrauchers bei erhöhter Stromaufnahme oder Ähnliches umfasst. Eine Anschlusseinrichtung ermöglicht den Anschluss externer Geräte oder externer elektrischer oder elektronischer Bauteile, beispielsweise eines externen Funkmoduls, einer Abschalt- oder Warneinrichtung, wie beispielsweise ein Schaltrelais zur Abschaltung der Verbraucherkontakte, oder eine Warneinrichtung in Form eines akustischen Signalgebers oder einer Warnleuchte. Durch Anordnung einer Anschlusseinrichtung an das Gehäuse eines Steckadapters werden die Einsatz-und Funktionalitätsmöglichkeiten der Strommessvorrichtung erheblich vergrößert, können höhere Kommunikationsreichweiten erreicht werden, Warnmöglichkeiten oder Selbstabschaltmöglichkeiten hinzugefügt werden, und somit die Anwendbarkeit der Strommessvorrichtung und die Betriebssicherheit erheblich vergrößert werden.

Gemäß eines weiteren Aspekts der vorliegenden Erfindung wird ein Verbraucherenergiemesssystem vorgeschlagen, das zumindest eine Strommessvorrichtung nach einem der vorgenannten Ausführungsbeispiele und zumindest eine Verbraucherenergieauswertevorrichtung, insbesondere ein intelligenter Zähler und/oder eine dezentrale Auswertevorrichtung, die eine Kommunikationseinrichtung zum drahtlosen Empfang zumindest eines Strommesswerts der Strommessvorrichtung umfasst, vorgeschlagen. Die Verbraucherenergieauswertevorrichtung ist ausgelegt, um die Strommesswerte zumindest einer, insbesondere aller Strommessvorrichtungen in Empfangsreichweite zu empfangen und daraus die verbrauchte Energie der Verbraucher auszuwerten und anzuzeigen. Nach diesem nebengeordneten Aspekt wird der Einsatz einer Strommessvorrichtung in einem Verbraucherenergiemesssystem vorgeschlagen, in dem eine Verbraucherenergieauswertevorrichtung, die ein intelligenter Zähler oder eine dezentrale Auswertevorrichtung, beispielsweise eine tragbare Empfangs- und Anzeigevorrichtung, zur Anzeige des Energieverbrauchs, Leistungsaufnahme und Stromaufnahme der angeschlossenen Verbraucher, die Messdaten der Strommessvorrichtung in Empfangsreichweite empfangen kann. Die Auswertevorrichtung empfängt dabei die Funk- oder optischen Signale der Strommessvorrichtung, und kann diese beispielsweise über eine vorbestimmte Zeit oder entlang einer Zeithistorie als Energieverbrauchswerte des Verbrauchers darstellen, eine Summendarstellung aller Energieverbräuche der empfangbaren Strommessvorrichtungen aufzeigen und in Kombination beispielsweise des gewählten Stromtarifs Maßnahmen vorschlagen, um einen günstigeren Stromtarif zu wählen oder einen niedrigeren Stromverbrauch zu erreichen. Des Weiteren kann die Verbraucherenergieauswertevorrichtung Hinweise auf einen ungewöhnlichen Energieverbrauch eines Verbrauchers liefern, beispielsweise wenn dessen Energieverbrauch signifikant gegenüber historischen Daten abweicht. Die von der Verbraucherenergieauswertevorrichtung aufgenommenen Daten können lokal ausgewertet, aber auch an eine entfernte Verbraucherenergiesammeleinrichtung weitergeleitet werden, so dass sowohl Versorgungsnetzbetreiber als auch Versorgungsnetzkunde sich über den Gesamtverbrauch aller oder der wesentlichen angeschlossenen Verbraucher innerhalb eines Haushalts oder mehrerer Haushalte informieren können.

Gemäß eines weiteren Aspekts des Verbraucherenergiemesssystems kann eine Spannungsmesseinrichtung eines intelligenten Zählers in Kommunikation mit der Verbraucherenergieauswerteeinrichtung, wobei die Verbraucherenergievorrichtung der intelligente Zähler selbst sein kann, zur Ermittlung der Verbraucherenergie stehen, und/oder die Strommessvorrichtung einen Strommesswert periodisch oder bei Änderung des Verbraucherstroms an die Verbraucherenergieauswertevorrichtung weitergeben. Durch Verbindung einer Spannungsmesseinrichtung eines intelligenten Zählers mit der Verbraucherenergieauswertevorrichtung stehen der Verbraucherenergieauswertevorrichtung die tatsächlichen Spannungswerte, die im Energieversorgungsnetz herrschen, zur Verfügung. Zusammen mit den Strommesswerten, die von der Strommessvorrichtung geliefert werden, kann die Leistung des Verbrauchers P=U*l aus Verbraucherstrom I und Netzspannung U und unter Berücksichtigung eines Zeitablaufs t der Energieverbrauch des Verbrauchers W=P*t bestimmt werden. Im Resultat lässt sich unter Berücksichtigung einer Spannungsmesseinrichtung, beispielsweise eines intelligenten Zählers eine exakte Verbraucherleistungsbestimmung erreichen, wobei im anderen Fall Schätzwerte, beispielsweise Spannungsnetzhöhe 240/300 Volt angenommen werden können. Des Weiteren ist es vorteilhaft, dass die Strommessvorrichtungen die Strommesswerte entweder periodisch, das heißt nach einem festen Zeittakt oder bei einer Änderung des Verbraucherstroms, beispielsweise bei signifikanter Erhöhung oder Senkung des Verbraucherstroms gegenüber einem vorher bestimmten Verbraucherstrom, messen und an die Verbraucherenergieauswertevorrichtung via drahtloser Kommunikation weitergeben kann. Dabei kann eine Funkverbindung verwendet werden, insbesondere nach einem Industriefunkstandard, beispielsweise WLAN/HomeRF oder im Bereich industriell eingesetzter Funkfernsteuerfrequenzen von 13 bis 45, 433 MHz oder im ISM-Band 2,4 GHz angesiedelt sein. Des Weiteren ist eine optische oder akustische Kommunikation, beispielsweise eine Infrarotverbindung oder eine Ultraschallverbindung denkbar, wobei dies zwangsläufig nur bei Ausformung der Strommessvorrichtung als Steckadapter oder bei Ausführung einer Kommunikationseinrichtung als externes Bauteil außerhalb eines Durchsteckgehäuses umsetzbar ist. Durch eine zeitweise periodisch oder auf Anforderung sendende Kommunikationseinrichtung wird der Eigenenergieverbrauch der Strommessvorrichtung gesenkt, so dass insbesondere bei Ausführung des Energiespeichers als durch die Induktivitätsspule wiederaufladbaren Energiespeicher eine hohe Lebensdauer, Wartungsfreiheit und Funktionalität der Strommessvorrichtung gewährleistet wird.

Gemäß eines weiteren Ausführungsbeispiels ist die Verbraucherenergieauswertevorrichtung mit einem Netzwerk, bevorzugt Internet mittels eines Netzwerkprotokolls, bevorzugt TCP/IP verbunden, wobei die Verbraucherenergieauswertevorrichtung die gemessenen Verbraucherenergiewerte in Form von Netzwerkabrufbaren Daten, bevorzugt XML-Daten an zumindest eines Speichervorrichtung im Netzwerk, bevorzugt eine Webapplikation übermitteln kann. Durch die Speichervorrichtung kann ein Versorgungsnetzkunde oder ein Versorgungsnetzbetreiber insbesondere über eine Website Zugriff auf die Verbraucherenergiewerte nehmen. Dieses Ausführungsbeispiel schlägt vor, dass die Verbraucherenergieauswertevorrichtung ihre gemessenen und empfangenen Energieverbrauchswerte an ein Netzwerk weitergibt, beispielsweise Internet aber auch an ein energienetzspezifisches Netzwerk, beispielsweise via Powerline-Communication (PLC, Trägerfrequenzanlage), wobei die Übertragung gemäß eines Standartnetzwerkprotokolls, wie beispielsweise TCP/IP erfolgen kann, und im Netzwerk die Verbraucherwerte in protokollierter Form, beispielsweise als XML-Datei oder HTML-Datei abgelegt werden können. Die Daten können insbesondere in einer Datenbankstruktur, wie sie beispielsweise eine Webapplikation bietet, abgelegt werden, so dass ein freier Zugriff von Außen vom beliebigen Netzwerkteilnehmern, insbesondere Versorgungsnetzkunden oder Versorgungsnetzbetreiber erfolgen kann, und sich beispielsweise so der Versorgungsnetzkunde über den Energieverbrauch aller an sein Verbraucherenergiemesssystem angeschlossenen Stromverbraucher innerhalb seines Haushalts über eine Website informieren kann.

Somit schlägt die Erfindung eine Strommessvorrichtung vor, die ähnlich wie eine Kindersicherung für eine Steckdose ausgestaltet sein kann, und die mit einer bestehenden Infrastruktur, beispielsweise einem intelligenten Zähler, kommunizieren kann. Dabei empfängt der Zähler die Strommessdaten der Strommesseinrichtung und leitet diese beispielsweise an eine Website weiter, wobei die Kommunikation über Funk abläuft, und die Daten beispielsweise über XML-Dateien mittels einer TCP/IP-Verbindung an eine Webapplikation geliefert werden kann. Aufgrund der hohen Integration und geringen Größe der Strommessvorrichtung kann diese sehr günstig, beispielsweise für weniger als 3 Euro hergestellt werden und verbraucht sehr viel weniger Leistung als herkömmliche Submeter (Zwischenzähler). Die Strommessvorrichtung kann in einer Steckdose, in einem Stecker oder in einem Kabel eingegossen oder eingesteckt sein und kann beispielsweise als billiges "Giveaway" vom Netzwerkbetreiber an Verbraucher für Versorgungsnetzkunden verschenkt oder kostengünstig abgegeben werden. Die Datensammlung der Strommesswerte kann mittels Harvest-Methode der einzelnen Strommessvorrichtungen erfolgen, wobei in den Ruhephasen der Akku der Strommessvorrichtungen über die induzierte Spannung der Messspulen geladen werden kann.

### Zeichnungen

Weitere Vorteile ergeben sich aus der folgenden Zeichnungsbeschreibung. In den Zeichnungen sind Ausführungsbeispiele der Erfindung dargestellt. Die Zeichnungen, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen beispielhaft:
- Fig. 1: schematische Blockdiagrammdarstellungen einer ersten und zweiten Ausführungsform einer Strommessvorrichtung mit Durchsteckgehäuse für ein Wechsel- und Drehstromversorgungsnetz;
- Fig. 2: schematische Blockdiagrammdarstellungen eine dritte und vierte Ausführungsform einer Strommessvorrichtung mit Steckadaptergehäuse für ein Wechsel- und Drehstromversorgungsnetz;
- Fig. 3: schematische Darstellung eines Ausführungsbeispiels einer Strommessvorrichtung mit Durchsteckgehäuse für eine WechselstromSchuko-Steckdose;
- Fig. 4: schematische Darstellung eines Ausführungsbeispiels einer erfindungsgemäßen Strommessvorrichtung als Durchsteckgehäuse für eine Drehstrom-CEE-Steckdose;
- Fig. 5: schematische dreidimensionale Darstellung eines Ausführungsbeispiels einer erfindungsgemäßen Strommessvorrichtung als Steckadapter;
- Fig. 6: schematische dreidimensionale Darstellung eines Ausführungsbeispiels einer erfindungsgemäßen Strommessvorrichtung als Steckdosenleiste;
- Fig. 7: schematische Darstellung eines Ausführungsbeispiels eines Verbraucherenergiemesssystems mit mehreren Strommessvorrichtungen, zwei Verbraucherenergieauswertevorrichtungen und angeschlossenem Netzwerk.

### Ausführungsformen der Erfindung

In den Figuren sind gleiche oder gleichartige Komponenten mit gleichen Bezugszeichen beziffert.

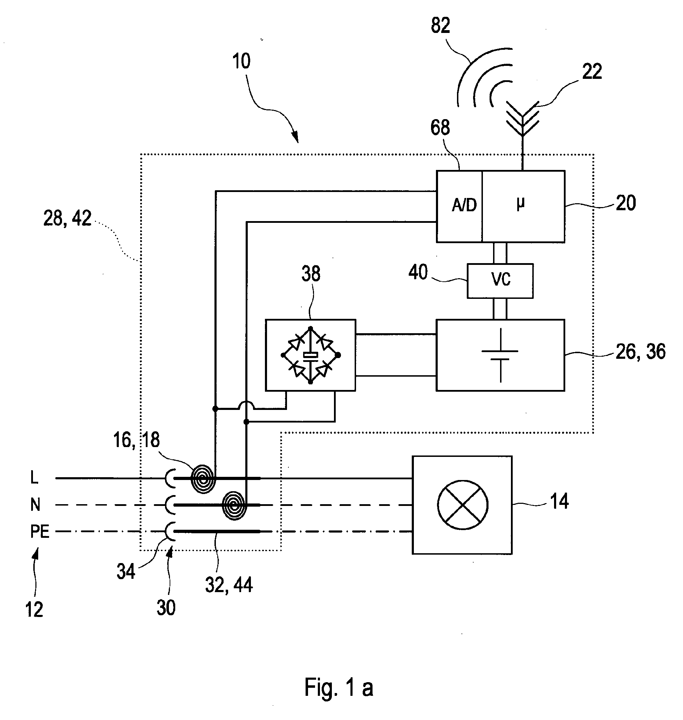

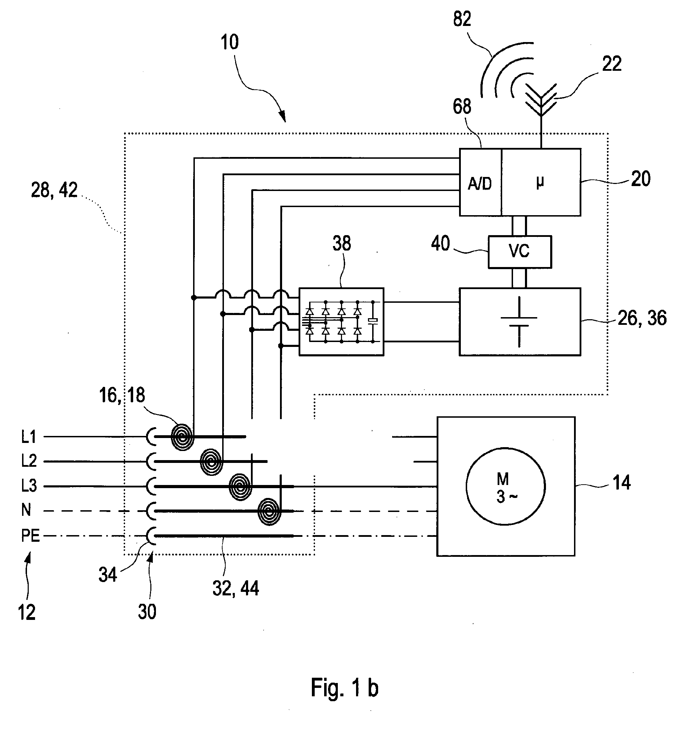

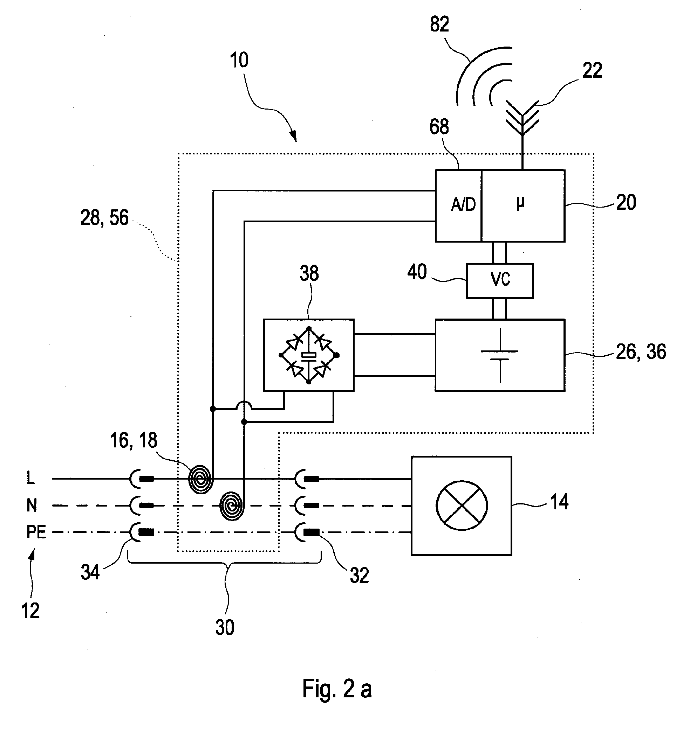

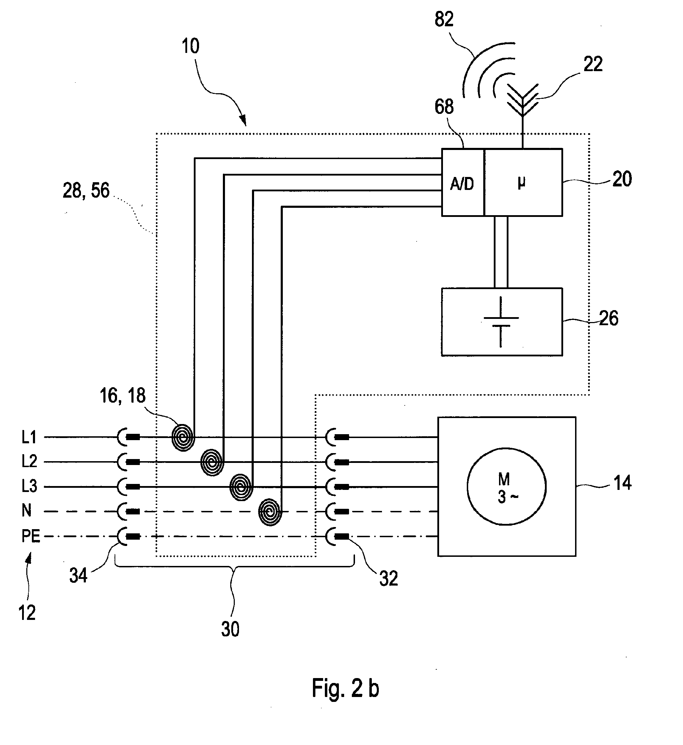

Zur Erläuterung der Erfindung zeigen die Figuren 1 und 2 in einer skizzenhaften Bockdarstellung die elektrische Konfiguration verschiedene Ausführungsbeispiele einer kontaktlosen Strommessvorrichtung 10.

In den nachfolgenden Darstellungen werden schematisch Magnetfeldsonden 16 als Induktivitätsspule 18 dargestellt, die durch eine schematische Verbindungslinie mit einer Auswerteeinrichtung 20 verbunden sind. Es versteht sich von selbst, dass jede Induktivitätsspule 18 mittels mindestens zweier elektrischer Verbindungsleitungen an die Auswerteeinrichtung 20 angeschlossen ist, um einen Stromfluss durch eine in die Induktivitätsspule 18 induzierte Spannung zu ermöglichen. Die Strommessvorrichtung 10 kann mittels zumindest einer Magnetfeldsonde 16 als Induktivitätsspule 18 betrieben werden. Zwei oder mehrere Magnetfeldsonden 16 als Induktivitätsspulen 18 können zur Erhöhung der Messgenauigkeit dienen, eine erhöhte Energiebereitstellung bewirken und können in einem Mehrphasennetz die Ströme einzelner oder aller stromführenden Phasen überwachen. Die in der Hin- und Rückleitung (L,N) oder in den mehreren Phasenleitern (L1, L2, L3, N) angeordneten Induktivitätsspulen 18 können in Reihe geschaltet sein. Eine Gleichrichtereinrichtung 38 kann zwischen den beiden Anschlussleitungen einer einzigen Magnetfeldsonde 16 als Induktivitätsspule 18 angeschlossen sein, oder zwischen einer Mehrzahl von Anschlussleitungen mehrerer Induktivitätsspulen 18 zwischengeschaltet sein.

Fig. 1a zeigt eine kontaktlose Strommessvorrichtung 10, bei der eine oder zwei Magnetfeldsonden 16 als Induktivitätsspulen 18 ausgelegt sind, die in elektrischem Kontakt mit einer Auswerteeinrichtung 20 in Form eines Mikroprozessors, stehen, wobei über eine Gleichrichtereinrichtung 38 Energie aus der induzierten Spannung der Induktivitätsspulen 18 zur Aufladung eines wiederaufladbaren elektrischen Energiespeichers 36 gewonnen und gleichgerichtet wird. Der wiederaufladbare Energiespeicher 36 ist über eine Spannungswandlungseinrichtung 40 an die Auswerteeinrichtung 20 zur Versorgung der Auswerteeinrichtung 20 und der Kommunikationseinrichtung 22 angeschlossen, wobei die Spannungswandlungseinrichtung 40 die zur Verfügung gestellte Spannung des Energiespeichers 36 in eine geeignete Betriebsspannung für die Auswerteeinrichtung 20 und die Kommunikationseinrichtung 22 umwandelt. Die Kommunikationseinrichtung 22 umfasst eine Antenne zur Aussendung eines Funkkommunikationssignals 82 und diverse HF-Modulations- und Sendebauteile .

Alle Einrichtungen der Strommessvorrichtung 10 sind in einem Zwischensteckgehäuse 28, das als Durchsteckgehäuse 42 ausgelegt ist, angeordnet. Das Durchsteckgehäuse 42 weist zumindest zwei Durchstecköffnungen 88 auf, um die die Induktivitätsspulen 18 gewickelt sind. Durch die Durchstecköffnungen 88 können die Kontaktstifte 44 eines Verbrauchersteckers 32 gesteckt werden, um anschließend die Kontaktstifte 32 in Steckbuchsen 46 einer Anschlussdose 34 einzustecken. Somit ist die gesamte Strommessvorrichtung 10 in einem Durchsteckgehäuse 42 angeordnet, das in der Steckverbindung 30 umfassend Anschlussdose 34 und Verbraucherstecker 32 zwischengesteckt ist. Die Netzanschlussdose 34 dient zum Anschluss eines Verbrauchers 14 an das elektrische Energieversorgungsnetz 12, wobei die Kontaktstifte 44 des Verbrauchersteckers 32 Kontakt zur Phase L, Nullleiter N und Schutzleiter PE herstellen. Die Induktivitätsspulen 18 werden durch das Magnetfeld des Verbraucherstroms, der durch Phase L und Nullleiter N durchflutet, wobei in den Spulen 18 eine Spannung entsprechend dem Stromfluss induziert wird. Theoretisch reicht zur Bestimmung des Stroms lediglich die Messung an einem Kontaktstift 44 aus. Die induzierte Spannung in der Induktivitätsspule 18 wird über einen A/D-Wandler 68 in digitale Werte umgewandelt, und von einem Mikroprozessor, der von der Auswerteeinrichtung 20 umfasst ist, ausgewertet, wobei der Verbraucherstrom unter Voraussetzung einer konstanten Spannung in einen Leistungswert und unter Berücksichtigung der Zeit in eine Verbrauchsenergie des angeschlossenen Verbrauchers 14 umgerechnet werden kann. Die gemessenen Werte werden über die Kommunikationseinrichtung 22 mittels Funkkommunikation 82 digital kodiert an eine nicht dargestellte Verbraucherenergieauswerteeinrichtung 24 übermittelt. In den inaktiven Zeiten von Auswerteeinrichtung 30 und Kommunikationseinrichtung 22 kann die induzierte Spannung in den Induktivitätsspulen 18 mittels einer Gleichrichtereinrichtung 38, die einen Brückengleichrichter umfasst, in Gleichspannung umgewandelt werden, die zur Aufladung des wiederaufladbaren Energiespeichers 36, beispielsweise eines Akkus oder eines hochkapazitiven Kondensators, dient. Die Spannung des Akkus oder Kondensators 36 kann über die Spannungswandlungseinrichtung 40, die beispielsweise einen Hochsetzsteller umfasst, an die Betriebsspannung des Mikroprozessors 20, A/D-Wandlers 68 und der Kommunikationseinrichtung 22 angepasst werden.

Ausgehend von Fig. 1a zeigt Fig. 1b die nahezu identische Konfiguration einer Strommessvorrichtung 10 allerdings für den Anschluss eines Verbrauchersteckers 32 eines Drehstromverbrauchers 14, beispielsweise Drehstrommotors, an eine CEE-Drehstromsteckdose 34 des Energieversorgungsnetzes 12. Entsprechend umfasst das Durchsteckgehäuse 42 vier Induktivitätsspulen 18, wobei theoretisch drei Induktivitätsspulen 18 um die drei Phasen L1, L2 und L3 zur Leistungserfassung genügen. Über einen A/D-Wandler 68 werden die induzierten Spannungsmesswerte digital gewandelt, über einen Mikroprozessor der Auswerteeinrichtung 20 der Verbraucherstrom berechnet, und mittels einer Kommunikationseinrichtung 22 über Funksignal 82 an eine nicht dargestellte Verbraucherenergieauswerteeinrichtung 24 gesendet. Zur Gewinnung von Energie zum Betrieb der Strommessvorrichtung dient ein Drehstrombrückengleichrichter 38, wobei jedoch eine andere Ausführungsform, beispielsweise als Zweibrückengleichrichter ausreichen kann, um einen wiederaufladbaren Energiespeicher 36 aufzuladen.

Fig. 2 zeigt in ähnlichen Ausführungen zur Fig. 1 ein Ausführungsbeispiel einer Wechselstrom- und Drehstrommessvorrichtung 10, wobei das Zwischensteckgehäuse als Steckadapter 56 ausgelegt ist. Der Zwischenadapter 56 wird in eine Steckverbindung 30 zwischen Energieversorgungsnetz 12 und Verbraucher 14 zwischengesteckt, wobei der Steckadapter 56 über eigene Steckkontakte 32 und Anschlusskupplung 34 verfügt, und die Steckkontakte 32 des Steckadapters 56 in die Netzanschlussdose 34 eingesteckt werden, wobei der Verbraucherstecker 32 in die Anschlusskupplung 34 des Steckadapters 56 eingesteckt wird. Ansonsten ist die elektrische Konfiguration der in Fig. 2a dargestellten Ausführungsform einer Strommessvorrichtung identisch mit dem in Fig. 1a dargestellten Ausführungsbeispiel.

Den obigen Ausführungsbeispielen nach Fig 1a, 1b und 2a ist gemeinsam, dass durch die Induktivitätsspulen 18 um die Steckkontakte 44 ein Kondensator oder ein Akku eines wiederaufladbaren Energiespeichers 36 aufgeladen werden. Dieser versorgt die Auswerteeinrichtung 20 mit Energie. Die Auswerteeinrichtung 20 kann periodisch die Spannung an den Induktivitätsspulen 18 messen und regelmäßig über Funk die Änderungen an eine externe Auswertevorrichtung 24 übermitteln. Eine Spannungsmessung durch die Strommessvorrichtung 10 ist nicht möglich, da kein galvanischer Kontakt zu den stromführenden Leitern besteht, so dass ein Spannungswert angenommen werden kann oder die Daten zusammen mit den Spannungswerten eines intelligenten Zählers 72 kombiniert werden können. Die Verbrauchsdaten können an einer zentralen Stelle, beispielsweise einer Speichervorrichtung 78, in einem Netzwerk 76 abgelegt werden und dem Versorgungsnetzkunden 80 oder einem Versorgungsnetzbetreiber zugänglich gemacht werden.

Fig. 2b zeigt eine weitere Ausführungsform einer Drehstrommessvorrichtung 10, die von einem Zwischenadaptergehäuse 56 entsprechend der Fig. 2a umfasst ist. Der Steckadapter 56 umfasst fünf Kontaktstifte eines Steckers 32, die in eine Drehstromsteckdose 34 eingesteckt werden, und stellt eine Anschlusskupplung 34 bereit, in der der Verbraucherstecker 32 eines Drehstrommotors 14 eingesteckt wird. Im Unterschied zur Ausführungsform der Figs. 1a, 1b und 2a verzichtet die Strommessvorrichtung 10 nach Fig. 2b auf einen wiederaufladbaren Energiespeicher, und besitzt statt dessen einen Energiespeicher in Form einer Batterie 26, deren Ausgangsspannung angepasst an die Betriebsspannung der Auswerte- und Kommunikationseinrichtung 20, 22 ist, so dass des Weiteren auf eine Spannungswandlungseinrichtung 40 verzichtet werden kann. Somit lässt sich eine kompaktere Bauweise realisieren, wobei die Strommessvorrichtung 10 nur eine begrenzte Lebensdauer aufweist bzw. nach gegebenen Zeit der Energiespeicher 26 aufgeladen bzw. erneuert werden muss.

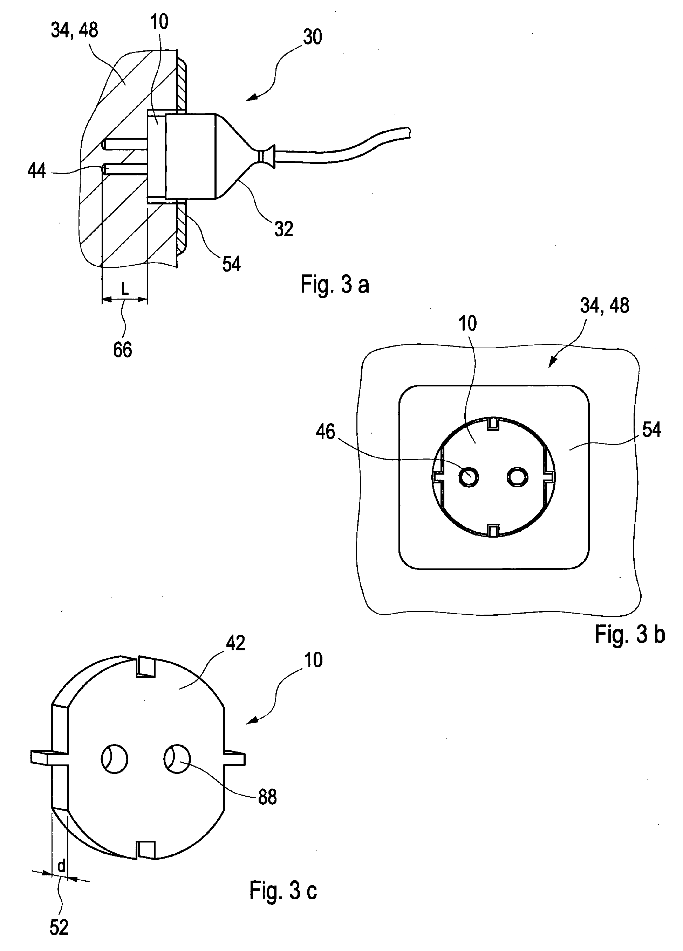

Fig. 3 zeigt ein Ausführungsbeispiel einer Strommessvorrichtung 10 für den Einsatz als Durchsteckgehäuse 42 für eine Schuko-Steckdose 48. Fig. 3a zeigt in einer Teilschnittdarstellung eine Steckverbindung 30 zwischen einem Verbraucherstecker 32 und einer Anschlussdose 34 in Form einer Schuko-Steckdose 48. Durch Zwischenstecken des Durchsteckgehäuses 42 der Strommessvorrichtung 10 zwischen Verbraucherstecker 32 und Anschlussdose 34 ragen die Kontaktstifte 44 des Verbrauchersteckers 32 lediglich mit einer Restlänge L 66 in die Anschlussbuchsen 46 der Schuko-Steckdose 48. Zur Erhaltung der elektrischen Betriebssicherheit ist es wesentlich, dass die Länge L 66 ausreicht, einen zuverlässigen elektrischen Kontakt der Kontaktstifte 44 des Verbrauchersteckers 32 mit den Steckdosenbuchsen 46 herzustellen. Dies kann vom Fachmann im Einzelfall durch Austesten der elektrischen Kontaktierung der Stift-Buchsen-Steckverbindung, insbesondere durch mechanisches Rütteln am Stecker 32, experimentell ausgetestet werden, um eine maximal zulässige Gehäusedicke d des Durchsteckgehäuses 42 festzulegen. Fig. 3b zeigt eine Draufsicht auf eine Schuko-Steckdose 48 mit eingelegtem Durchsteckgehäuse 42 in dem Topf der Anschlussdosenabdeckung 54. Fig. 3c zeigt in einer perspektivischen dreidimensionalen Darstellung die Gestaltung des Durchsteckgehäuses 42, dessen äußere Kontur im Wesentlichen der inneren Kontur der Anschlussdosenabdeckung 54 einer Schuko-Steckdose 48 gleicht. Das Durchsteckgehäuse 42 weist Durchgangsöffnungen 88 auf, durch die die Steckkontakte 44 eines Verbrauchersteckers gesteckt werden können, und die die Anschlusskontakte der Steckdosenbuchse 46 der Schuko-Steckdose 48 freilegen. Das Durchsteckgehäuse 42 weist eine Dicke d 52 auf, die entsprechend gewählt werden muss, um einen zuverlässige elektrische Kontaktierung von Kontaktstifte 44 des Verbrauchersteckers 32 mit Steckdosenbuchsen 46 beim Einstecken in eine Schuko-Steckdose 48 zu gewährleisten.

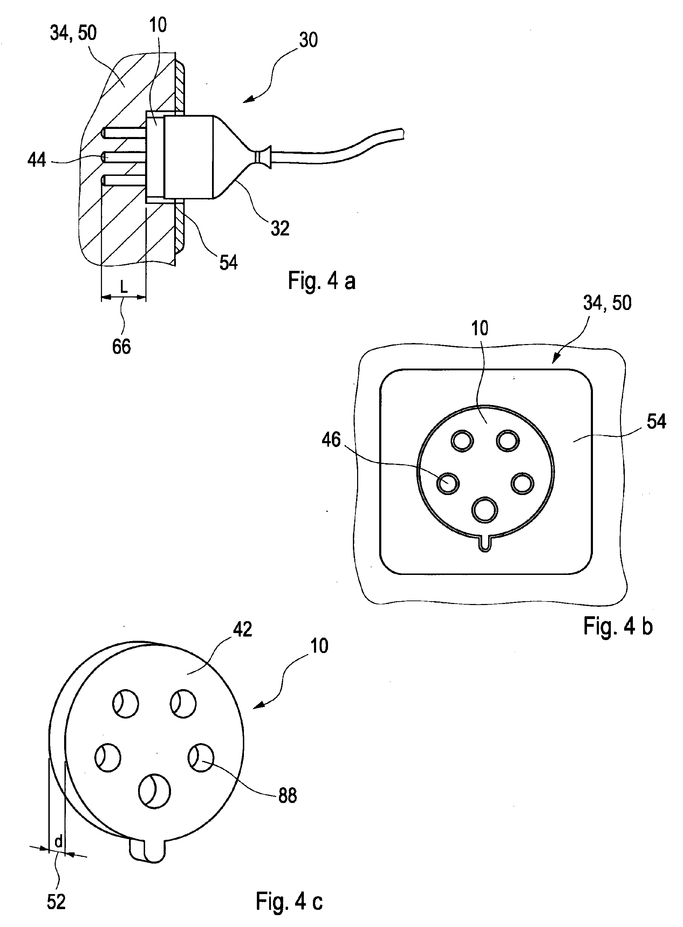

In analoger Darstellung wie die Fig. 3 zeigt die Fig. 4 ein Ausführungsbeispiel eines Durchsteckgehäuses für den Einsatz an einer Drehstrom-Steckverbindung 30 zwischen CEE-Drehstromstecker 32 und CEE-Steckdose 50. Fig. 4a stellt in einer Teilschnittdarstellung und Fig. 4b in einer Vorderansicht eine Steckverbindung 30 eines Drehstromanschlusses dar, wobei eine Länge L (66) der Kontaktstifte 44 des CEE-Steckers 32 ausreichend sein muss, um elektrisch zuverlässig in den Kontaktbuchsen 46 der CEE-Steckdose 50 verankert zu sein. Das Durchsteckgehäuse 42 ist formkomplementär zur Innenwandgestaltung des Anschlusstopfes der Anschlussdosenabdeckung 54 ausgestaltet und weist eine Dicke d auf, die weniger als 15% der Gesamtlänge eines Kontaktstiftes 44 eines Verbrauchersteckers 32 aufweist, so dass die Länge L 66 mehr als 85% der Gesamtlänge des Kontaktstiftes 44 ausmacht. Entsprechend der Fig. 3c ist Fig. 4c eine perspektivische Darstellung des Durchsteckgehäuses, wobei Durchgangsöffnungen 88 erkennbar sind, die die Kontaktstifte 44 des Steckers 32 eng umschließen, wobei im Inneren des Durchsteckgehäuses 42 nicht sichtbar Induktivitätsspulen 18 um die Durchgangsöffnungen 88 zur Messung des die Kontaktstifte 44 umgebenden Magnetfelds angeordnet sind.

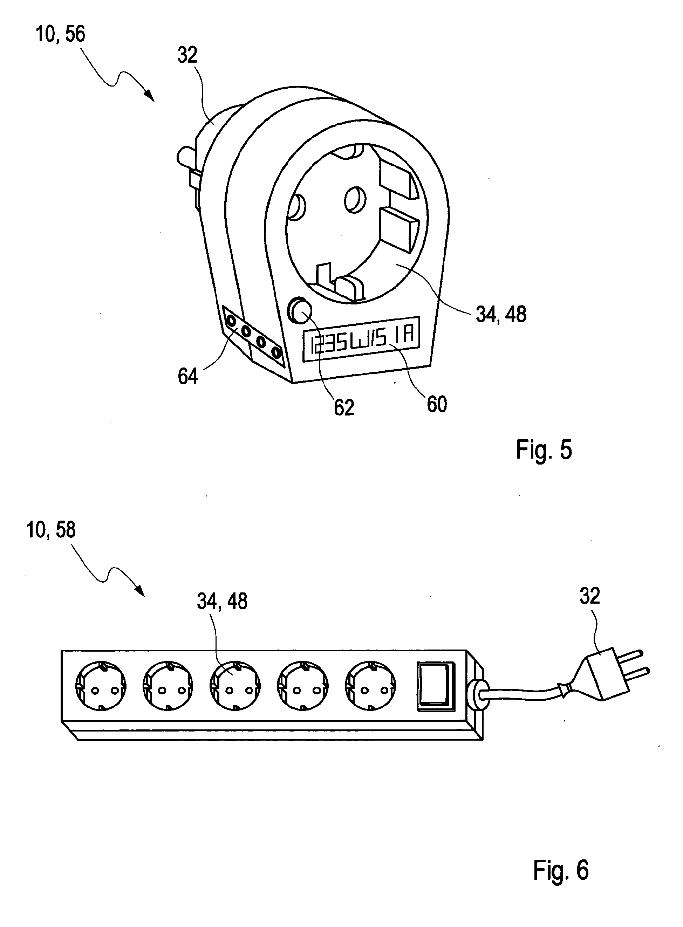

Fig. 5 zeigt eine Ausführungsform einer Stromessvorrichtung 10 in Form eines Steckadapters 56. Der Steckadapter 56 umfasst eine Anschlusskupplung 34 als Schuko-Steckdose und einen Stecker 32, der zwei Kontaktstifte sowie einen Schutzkontakt umfasst. Die Einrichtungen der Strommessvorrichtung 10 sind im Inneren des Steckadaptergehäuses angeordnet und auf der Außenfläche des Gehäuses ist eine Anzeigeeinrichtung 60 zur Anzeige eines Strom- und Leistungsaufnahmewertes eines angeschlossenen Verbrauchers angebracht, wobei mittels einer Anzeigetaste 62 die Anzeige 60 aktiviert werden kann, die für eine vorbestimmbare Zeit Energieverbrauch und Stromaufnahme eines angeschlossenen Verbrauchers anzeigen kann. Zur Erweiterung der Funktionalität der Strommessvorrichtung 10 ist ebenfalls in der Gehäusewandung eine Anschlusseinrichtung 64 vorgesehen, an der nicht dargestellte externe Zusatzeinrichtungen, beispielsweise eine Funksendeeinrichtung zur Erweiterung des Empfangsbereichs, zusätzliche Warneinrichtungen, beispielsweise Blinklicht oder akustische Warnsignalgeber bei Überschreitung einer kritischen Stromentnahme eines Verbrauchers oder eine externe Abschalteinrichtung, beispielsweise ein Schaltrelais zum Abschalten des Verbrauchers bei erhöhter Stromaufnahme, angeschlossen werden können. Des Weiteren kann die Anschlusseinrichtung 64 zur Aufladung eines internen Energiespeichers 26 dienen.

Fig. 6 zeigt ein Ausführungsbeispiel einer Strommessvorrichtung 10, die in einer Steckdosenleiste 58 integriert ist. Hierzu umfasst die Steckdosenleiste 58 einen Verbraucherstecker 32 und eine Mehrzahl von Schuko-Steckdosen 48, wobei die Strommessvorrichtung 10 sowohl im Verbraucherstecker 32 integriert sein kann, als auch in dem Gehäuse der Steckdosenleiste 58 eingebaut sein kann.

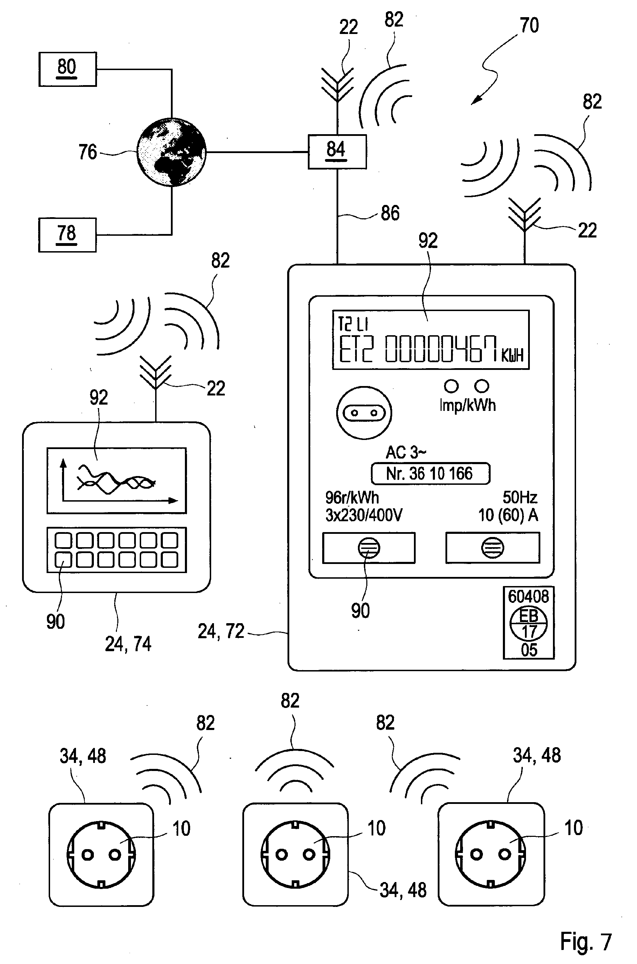

Schließlich zeigt Fig. 7 ein Verbraucherenergiemesssystem 70, das drei Strommesseinrichtungen 10, die in Schuko-Steckdosen 48 angeordnet sind, umfasst, die via Funkkommunikation 82 Signale an zwei Verbraucherenergieauswerteeinrichtungen 24 senden. Eine der Verbraucherenergieauswerteeinrichtungen 24 ist eine tragbare, dezentrale Auswertevorrichtung 74, die die Signale der Strommessvorrichtungen empfängt, speichert und als Historie anzeigen und auswerten kann, wobei Leistungsauswertungen sowie Energieverbrauch der angeschlossenen Verbraucher über eine gewisse Zeitspanne darstellbar ist. Die Strommessvorrichtungen 10 senden ihre Strommesswerte versehen mit einer Strommessvorrichtungsspezifischen ID aus, damit der betrachtete Verbraucher im Haushalt identifiziert werden kann. Die Auswertevorrichtung 74 umfasst eine Anzeigeeinrichtung 92 und Bedientasten 90, mit denen die Anzeige umgeschaltet und die Auswertung von Messdaten gesteuert werden können. Die Auswertevorrichtung 74 umfasst des Weiteren zur Herstellung der Funkkommunikation ebenfalls eine Kommunikationseinrichtung 22, die Funkkommunikationssignale der Strommessvorrichtungen 10 empfängt und Daten an einen Netzwerkrouter 84 sendet, der die empfangenen Verbrauchsdaten über ein Netzwerk 76 an eine Speichervorrichtung 78 im Netzwerk 78, beispielsweise an einen Webapplikationsserver des Internets via eines Netzwerkprotokolls, beispielsweise TCP/IP, übermittelt. Somit können die gemessenen Verbrauchsdaten zentral in einer Speichervorrichtung 78 eines Netzwerks 76 abgelegt werden. Versorgungsnetzwerkkunden oder Versorgungsnetzbetreiber 80 können ebenfalls über das Netzwerk 76 Zugriff auf die Energieverbrauchsdaten des angeschlossenen Haushalts nehmen.

Des weiterten umfasst das betrachtete Verbraucherenergiemesssystem 70 einen intelligenten Zähler 72 als Verbraucherenergieauswertevorrichtung 24, der ebenfalls über eine Funkkommunikationseinrichtung 22 die ID-gekennzeichneten Signale der Strommesseinrichtungen 10 empfängt, und diese auf einer Anzeigeeinrichtung 90 darstellen kann. Mittels Bedientasten 92 können verschiedene Anzeigewerte und Auswertungsmöglichkeiten auf der Bedieneinrichtung 90 angezeigt werden, und mittels einer bidirektionalen Kommunikationseinrichtung 22 bzw. über eine drahtgebundene Verbindung 86 die Daten an den Router 84 des Netzwerks 76 weitergeleitet werden. Im Zähler 72 kann die verbrauchte Energie exakt unter Berücksichtigung einer gemessenen Netzspannung bestimmt werden.

Das Verbraucherenergiemesssystem 70 ermöglicht die gezielte Erfassung des Energieverbrauchs einzelner Verbraucher in einem Haushalt dezentral und/oder zentral, wobei energieverschwendende Verbraucher erkannt und Maßnahmen zur Energieeinsparung eingeleitet werden können. Durch Einbindung einer erfindungsgemäßen Strommesseinrichtung an das Konzept eines intelligenten Zählers 72 kann eine individuelle Überwachung einzelner Verbraucher im Haushalt kostengünstig und einfach durch einen Versorgungsnetzkunden realisierbar eingerichtet werden, so dass Quellen hohen Energieverbrauchs im Haushalt leicht entdeckt werden können, der Kunde einen Überblick über den momentanen Energieverbrauch erhält und die Energieversorgung transparenter und kostengünstiger gestaltet werden kann.

### Bezugszeichenliste

- 10: Strommessvorrichtung
- 12: Energieversorgungsnetz
- 14: Verbraucher
- 16: Magnetfeldsonde
- 18: Induktivitätsspule
- 20: Auswerteeinrichtung
- 22: Kommunikationseinrichtung
- 24: Verbraucherenergieauswertevorrichtung
- 26: Energiespeicher
- 28: Zwischensteckgehäuse
- 30: Steckverbindung
- 32: Verbraucherstecker
- 34: Anschlussdose / Anschlusskupplung
- 36: wiederaufladbarer elektrischer Energiespeicher
- 38: Gleichrichtereinrichtung
- 40: Spannungswandlungseinrichtung
- 42: Durchsteckgehäuse
- 44: Stecker-Kontaktstift
- 46: Steckdosenbuchse
- 48: Schuko-Steckdose
- 50: CEE-Steckdose
- 52: Gehäusedicke des Durchsteckgehäuses d
- 54: Anschlussdosenabdeckung
- 56: Steckadapter
- 58: Steckdosenleiste
- 60: Anzeigeneinrichtung
- 62: Anzeigentaste
- 64: Anschlusseinrichtung
- 66: Kontaktstiftlänge L
- 68: A/D-Wandler
- 70: Verbraucherenergiemesssystem
- 72: intelligenter Zähler
- 74: dezentrale Auswertevorrichtung
- 76: Netzwerk
- 78: Speichervorrichtung im Netzwerk
- 80: Versorgungsnetzkunde oder Versorgungsnetzbetreiber
- 82: Funkkommunikation
- 84: Netzwerk-Router
- 86: Drahtgebundene Netzwerkverbindung
- 88: Durchstecköffnung
- 90: Bedientasten
- 92: Anzeigeeinrichtung

## Patentansprüche

1. Kontaktlose Strommessvorrichtung (10) für die Bestimmung einer elektrischen Verbrauchsenergie eines mittels eines Verbrauchersteckers (32) an ein elektrisches Wechsel- oder Drehstrom-Energieversorgungsnetz (12) anschließbaren Verbrauchers (14), umfassend
- zumindest eine Magnetfeldsonde (16) zur Messung der Stärke eines Magnetfelds einer stromdurchflossenen Verbraucherleitung;
- eine Auswerteeinrichtung (20) im elektrischen Kontakt mit der Magnetfeldsonde (16) zur Bestimmung des vom Verbraucher (14) aufgenommenen elektrischen Stroms;
- eine Kommunikationseinrichtung (22) zur drahtlosen Weitergabe zumindest des bestimmten Stromwerts an zumindest eine Verbraucherenergieauswertevorrichtung (24);
- einen elektrischen Energiespeicher (26), insbesondere Batterie, Akkumulator oder Kondensator zur elektrischen Energieversorgung zumindest der Auswerteeinrichtung (20) und der Kommunikationseinrichtung (22), wobei die Strommessvorrichtung (10) galvanisch vom Energieversorgungsnetz (12) getrennt ist,
wobei zumindest die Magnetfeldsonde (16) in einem Zwischensteckgehäuse (28) angeordnet ist, das dazu geeignet ist, in einer Steckverbindung (30) zwischen Verbraucherstecker (32) und Anschlussdose (34)/Anschlusskupplung des Energieversorgungsnetzes (12) zwischengeschaltet zu werden,
**dadurch gekennzeichnet, dass** die Magnetfeldsonde (16) eine Induktivitätsspule (18) ist, und dass der elektrische Energiespeicher (26) ein wiederaufladbarer elektrischer Energiespeicher (36), insbesondere Akkumulator oder Kondensator ist, und dass zwischen Induktivitätsspule (18) und Energiespeicher (26) zumindest eine Gleichrichtereinrichtung (38) geschaltet ist, so dass der Energiespeicher (26) mittels einer induzierten Spannung in der Induktivitätsspule (18) aufladbar ist.

2. Strommessvorrichtung nach Anspruch 1, **dadurch gekennzeichnet, dass** zwischen Induktivitätsspule (18) und wiederaufladbarem elektrischen Energiespeicher (36) eine Spannungswandlungseinrichtung (40) zur Anpassung der induzierten Spannung der Induktivitätsspule (18) an eine Ladespannung zur Aufladung des wiederaufladbaren elektrischen Energiespeichers (36) geschaltet ist.

3. Strommessvorrichtung nach einem der vorangegangenen Ansprüche, **dadurch gekennzeichnet, dass** zwischen Energiespeicher (26) und Auswerteeinrichtung (20) eine Spannungswandlungseinrichtung (40) zur Anpassung der Ausgangsspannung des Energiespeichers (26) an die Versorgungsspannung der Auswerteeinrichtung (20) geschaltet ist.

4. Strommessvorrichtung nach einem der vorangegangenen Ansprüche, **dadurch gekennzeichnet, dass** die gesamte Strommessvorrichtung (10) von dem Zwischensteckgehäuse (28) umfasst ist.

5. Strommessvorrichtung nach einem der vorangegangenen Ansprüche, **dadurch gekennzeichnet, dass** das Zwischensteckgehäuse (28) in Form eines Durchsteckgehäuses (42) zum Durchstecken von Kontaktstiften (44) eines Verbrauchersteckers (32) ausgelegt ist, dessen äußere Kontur formkomplementär zur inneren Kontur der Anschlussdose (34)/Anschlusskupplung, insbesondere Schuko-Steckdose (48), Euro-Steckdose, Perilex-Steckdose, CEE-Steckdose (50) oder vergleichbarer Steckdose ausgeformt ist, und dessen Gehäusedicke d (52) eine sichere elektrische Verbindung zwischen Stecker-Kontaktstift (44) und Steckdosenbuchse (46) gewährleisten kann, insbesondere die Gehäusedicke d (52) weniger als 40% der Kontaktstiftlänge (66) eines Verbrauchersteckers (32), und bevorzugt weniger als 25% der Kontaktstiftlänge (66) beträgt.

6. Strommessvorrichtung nach Anspruch 5, **dadurch gekennzeichnet, dass** das Durchsteckgehäuses (42) zumindest ein Befestigungsmittel, insbesondere Klebemittel, Schraubenverbindungsmittel, Klemmmittel oder Ähnliches zur Befestigung des Durchsteckgehäuses (42) an die Innenfläche des Buchsenbereichs der Anschlussdose (34)/Anschlusskupplung umfasst.

7. Strommessvorrichtung nach Anspruch 5 oder 6, **dadurch gekennzeichnet, dass** das Durchsteckgehäuses (42) ausgeformt ist, um bei der Herstellung einer Anschlussdosenabdeckung (54) oder eines Kupplungsgehäuses in die Innenfläche des Buchsenbereichs der Anschlussdose (34)/Anschlusskupplung eingegossen werden zu können.

8. Strommessvorrichtung nach einem der vorangegangenen Ansprüche 1 bis 4, **dadurch gekennzeichnet, dass** das Zwischensteckgehäuse (28) in Form eines Steckadapters (56) oder einer Steckdosenleiste (58) ausgeformt ist, wobei das Zwischensteckgehäuse (28) zumindest eine Anschlussdose (34) bzw. Anschlusskupplung zum Anschluss eines oder mehrerer Verbraucher (14) und einen Verbraucherstecker (32) zum Anschluss an eine Anschlussdose (34)/Anschlusskupplung eines Energieversorgungsnetzes (12) umfasst.

9. Strommessvorrichtung nach Anspruch 8, **dadurch gekennzeichnet, dass** der Steckadapter (56) eine Anzeigeneinrichtung (60) umfasst, insbesondere LCD- oder LED- Anzeigeneinrichtung, die im elektrischen Kontakt mit der Auswerteeinrichtung (20) steht und die eingerichtet ist, die Stromaufnahme des angeschlossenen Verbrauchers (14) zumindest auf Anforderung mittels der Betätigung einer Anzeigentaste (62) anzuzeigen.

10. Strommessvorrichtung nach Anspruch 8 oder 9, **dadurch gekennzeichnet, dass** der Steckadapter (56) zumindest eine Anschlusseinrichtung (64) im elektrischen Kontakt mit der Auswerte- (20) und/oder Kommunikationseinrichtung (22) zum Anschluss weiterer Einrichtungen, insbesondere einer externen Anzeigeeinrichtung, einer Funkeinrichtung zur Erhöhung der Sendereichweite der Kommunikationseinrichtung (22), eine Abschalt- oder Warneinrichtung zur Abschaltung des Verbrauchers (14) bei erhöhter Stromaufnahme oder Ähnliches umfasst.

11. Verbraucherenergiemesssystem (70) umfassend zumindest eine Strommessvorrichtung (10) nach einem der vorangehenden Ansprüche und zumindest eine Verbraucherenergieauswertevorrichtung (24), insbesondere einen intelligenten Zähler (72) und/oder eine dezentrale Auswertevorrichtung (74), die eine Kommunikationseinrichtung zum drahtlosen Empfang zumindest eines Strommesswertes der Strommessvorrichtung (10) umfasst, wobei die Verbraucherenergieauswertevorrichtung (24) ausgelegt ist, Strommesswerte zumindest einer, insbesondere aller Strommessvorrichtungen (10) in Empfangsreichweite zu empfangen, und daraus die verbrauchte Energie auszuwerten und anzuzeigen.

12. Verbraucherenergiemesssystem nach Anspruch 11, **dadurch gekennzeichnet, dass** eine Spannungsmesseinrichtung eines intelligenten Zählers (72) in Kommunikation mit der Verbraucherenergieauswertevorrichtung (24) zur Ermittlung der Verbraucherenergie steht, und/oder dass die Strommessvorrichtung (10) einen Strommesswert periodisch oder bei Änderung des Verbraucherstroms an die Verbraucherenergieauswertevorrichtung (24) weitergibt.

13. Verbraucherenergiemesssystem nach Anspruch 11 oder 12, **dadurch gekennzeichnet, dass** die Verbraucherenergieauswertevorrichtung (24) mit einem Netzwerk (76), bevorzugt im Internet mittels eines Netzwerkprotokolls, bevorzugt mittels TCP/IP in Verbindung steht, wobei die Verbraucherenergieauswertevorrichtung (24) die gemessenen Verbraucherenergiewerte in Form von Netzwerk abrufbaren Daten, bevorzugt XML-Daten an zumindest eine Speichervorrichtung im Netzwerk (78), bevorzugt eine Webapplikation übermitteln kann, wobei einem Versorgungsnetzkunden oder Versorgungsnetzbetreiber (80) über das Netzwerk (76), insbesondere über eine Website, Zugriff auf die Verbraucherenergiewerte gewährt werden kann.

## Claims

1. Non-contact current measuring device (10) for determining an electric energy consumption of a consumer (14) connectable by means of a consumer plug (32) to an electric AC or 3-phase AC energy supply network (12), comprising
- at least one magnetic field probe (16) for measuring the strength of a magnetic field of a current-carrying consumer lead;
- an evaluation unit (20) in electric contact with the magnetic field probe (16) for determining the electric current received by the consumer (14);
- a communication unit (22) for wireless transmission of at least the determined current value to at least one energy consumption evaluation device (24);
- an electric energy storage device (26), in particular a battery, accumulator or capacitor, for supplying electric energy to at least the evaluation unit (20) and the communication unit (22), where the current measuring device (10) is galvanically isolated from the energy supply network (12),
where at least the magnetic field probe (16) is arranged inside an intermediate plug housing (28) that is suitable for insertion in a plug connection (30) between the consumer plug (32) and the connection socket (34) / connection coupling of the energy supply network (12),
**characterized in that** the magnetic field probe (16) is an inductance coil (18) and **in that** the electric energy storage device (26) is a rechargeable energy storage device (36), in particular an accumulator or capacitor, and **in that** at least one rectifier unit (38) is inserted between the inductance coil (18) and the energy storage device (26), such that the energy storage device (26) can be charged by means of an induced voltage in the inductance coil (18).

2. Current measuring device according to claim 1, **characterized in that** a voltage conversion unit (40) is inserted between the inductance coil (18) and the rechargeable electric energy storage device (36) for adapting the induced voltage of the inductance coil (18) to a charge voltage for charging the rechargeable electric energy storage device (36).

3. Current measuring device according to one of the preceding claims, **characterized in that** a voltage conversion unit (40) is inserted between the energy storage device (26) and the evaluation unit (20) for adapting the output voltage of the energy storage device (26) to the supply voltage of the evaluation unit (20).

4. Current measuring device according to one of the preceding claims, **characterized in that** the entire current measuring device (10) is enclosed by an intermediate plug housing (28).

5. Current measuring device according to one of the preceding claims, **characterized in that** the intermediate plug housing (28) is designed in the form of a through-type plug housing (42) for passing through contact pins (44) of a consumer plug (32) whose outer contour is shaped to complement the inner contour of the connection socket (34) / connection coupling, in particular earthed Schuko-socket (48), Euro socket, Perilex socket, CEE socket (50) or comparable socket, and whose housing thickness d (52) can ensure a secure electric connection between the plug contact pin (44) and the socket (46), in particular the housing thickness d (52) is less than 40% of the contact pin length (66) of a consumer plug (32) and preferably less than 25% of the contact pin length (66).

6. Current measuring device according to claim 5, **characterized in that** the through-type plug housing (42) comprises at least one fastening means, in particular adhesive, screw connection means, clamping means or similar, for fastening the through-type plug housing (42) to the inner face of the socket area of the connection socket (34) / connection coupling.

7. Current measuring device according to claim 5 or 6, **characterized in that** the through-type plug housing (42) is shaped in order to be integrally cast into the inner face of the socket area of the connection socket (34) / connection coupling during manufacture of a connection socket cover (54) or of a coupling housing.

8. Current measuring device according to one of the preceding claims 1 to 4, **characterized in that** the intermediate plug housing (28) is shaped in the form of a plug adapter (56) or a multiple socket outlet (58), where the intermediate plug housing (28) comprises at least one connection socket (34) or connection coupling for connecting one or more consumers (14) and a consumer plug (32) for connection to a connection socket (34) / connection coupling of an energy supply network (12).

9. Current measuring device according to claim 8, **characterized in that** the plug adapter (56) comprises a display unit (60), in particular an LCD or LED display unit, which is in electric contact with the evaluation unit (20) and which is set up to display the current input of the connected consumer (14) at least on request by actuating a display button (62).

10. Current measuring device according to claim 8 or 9, **characterized in that** the plug adapter (56) comprises at least one connection unit (64) in electric contact with the evaluation unit (20) and/or communication unit (22) for the connection of further units, in particular an external display unit, a radio unit for increasing the transmission range of the communication unit (22), a shutdown or warning unit to switch off the consumer (14) in the event of increased current input, or similar.

11. Energy consumption measurement system (70) comprising at least one current measuring device (10) according to one of the preceding claims and at least one energy consumption evaluation device (24), in particular an intelligent counter (72) and/or a decentralized evaluation device (74) comprising a communication unit for wireless reception of at least one current measurement value of the current measuring device (10), where the energy consumption evaluation device (24) is designed to receive current measurement values of at least one and in particular of all current measuring devices (10) within reception range, and from these to evaluate and display the consumed energy.

12. Energy consumption measurement system according to claim 11, **characterized in that** a voltage measurement unit of an intelligent counter (72) is in communication with the energy consumption evaluation device (24) for ascertaining the energy consumption, and/or that the current measuring device (10) transmits a current measurement value to the energy consumption evaluation device (24) periodically or when the consumer current changes.

13. Energy consumption measurement system according to claim 11 or 12, **characterized in that** the energy consumption evaluation device (24) is linked to a network (76), preferably in the internet by means of a network protocol, preferably by means of TCP/IP, where the energy consumption evaluation device (24) can transmit the measured energy consumption values in the form of data retrievable from the network, preferably XML data, at at least one storage device in the network (78), preferably a web application, where a supply network customer or supply network operator (80) can be granted access to the energy consumption values via the network (76), in particular via a website.

## Revendications

1. Dispositif de mesure de courant sans contact (10) pour la détermination d'une énergie électrique consommée par un consommateur (14) connectable à un réseau d'alimentation en courant alternatif ou triphasé (12) au moyen d'un connecteur de consommateur (32), ledit dispositif comprenant :
- au moins une sonde de champ magnétique (16) pour mesurer l'intensité d'un champ magnétique d'un câble de consommateur traversé par un courant ;
- un dispositif d'évaluation (20) en contact électrique avec la sonde de champ magnétique (16) pour déterminer le courant électrique absorbé par le consommateur (14) ;
- un dispositif de communication (22) pour la transmission sans fil d'au moins la valeur de courant déterminée à au moins un dispositif d'évaluation d'énergie consommée (24) ;
- une unité de stockage d'énergie électrique (26), en particulier batterie, accumulateur ou condensateur, pour alimenter en énergie électrique au moins le dispositif d'évaluation (20) et le dispositif de communication (22), le dispositif de mesure de courant (10) étant séparé galvaniquement du réseau d'alimentation en courant (12),
sachant qu'au moins la sonde de champ magnétique (16) est disposée dans un boîtier de connexion intermédiaire (28) qui est susceptible d'être intercalé dans un raccord à fiches (30) entre le connecteur de consommateur (32) et une prise de courant (34) / un connecteur du réseau d'alimentation en courant (12),
**caractérisé en ce que** la sonde de champ magnétique (16) est une bobine d'induction (18), et que l'unité de stockage d'énergie électrique (26) est une unité de stockage d'énergie électrique rechargeable (36), en particulier un accumulateur ou un condensateur, et qu'entre la bobine d'induction (18) et l'unité de stockage d'énergie (26) est monté au moins un dispositif redresseur (38), de sorte que l'unité de stockage d'énergie (26) peut être chargée au moyen d'une tension induite dans la bobine d'induction (18).

2. Dispositif de mesure de courant selon la revendication 1, **caractérisé en ce qu'**entre la bobine d'induction (18) et l'unité de stockage d'énergie électrique rechargeable (36) est monté un dispositif transformateur de tension (40) pour adapter la tension induite de la bobine d'induction (18) à une tension de charge pour charger l'unité de stockage d'énergie électrique rechargeable (36).

3. Dispositif de mesure de courant selon l'une des revendications précédentes, **caractérisé en ce qu'**entre l'unité de stockage d'énergie (26) et le dispositif d'évaluation (20) est monté un dispositif transformateur de tension (40) pour adapter la tension de sortie de l'unité de stockage d'énergie (26) à la tension d'alimentation du dispositif d'évaluation (20).

4. Dispositif de mesure de courant selon l'une des revendications précédentes, **caractérisé en ce que** la totalité du dispositif de mesure de courant (10) est contenue dans le boîtier de connexion intermédiaire (28).

5. Dispositif de mesure de courant selon l'une des revendications précédentes, **caractérisé en ce que** le boîtier de connexion intermédiaire (28) est conçu sous la forme d'un boîtier d'insertion (42) pour insérer des broches de contact (44) d'un connecteur de consommateur (32), dont le contour extérieur a une forme complémentaire au contour intérieur de la prise de courant (34) / du connecteur, en particulier prise à contact de protection Schuko (48), prise Euro, prise Perilex, prise CEE (50) ou prise comparable, et dont l'épaisseur de boîtier d (52) peut garantir une jonction électrique sûre entre la broche de contact (44) du connecteur et la douille de prise (46), sachant qu'en particulier l'épaisseur de boîtier d (52) est égale à moins de 40 % de la longueur de la broche de contact (66) d'un connecteur de consommateur (32), et de préférence à moins de 25 % de la longueur de la broche de contact (66).

6. Dispositif de mesure de courant selon la revendication 5, **caractérisé en ce que** le boîtier d'insertion (42) comprend au moins un moyen de fixation, en particulier un moyen de collage, un moyen de vissage, un moyen de serrage ou similaire afin de fixer le boîtier d'insertion (42) sur la surface intérieure de la zone de la douille de la prise de courant (34) / du connecteur.

7. Dispositif de mesure de courant selon la revendication 5 ou 6, **caractérisé en ce que** le boîtier d'insertion (42) est façonné pour pouvoir être coulé dans la surface intérieure de la zone de la douille de la prise de courant (34) du connecteur lors de la fabrication d'une plaque de recouvrement de prise de courant (54) ou d'un corps de connecteur.

8. Dispositif de mesure de courant selon l'une des revendications 1 à 4 précédentes, **caractérisé en ce que** le boîtier de connexion intermédiaire (28) est façonné sous la forme d'un adaptateur embrochable (56) ou d'une prise multiple (58), sachant que le boîtier de connexion intermédiaire (28) comprend au moins une prise de courant (34) ou un connecteur pour connecter un ou plusieurs consommateur(s) (14), et un connecteur de consommateur (32) pour connexion à une prise de courant (34) / un connecteur d'un réseau d'alimentation en courant (12).

9. Dispositif de mesure de courant selon la revendication 8, **caractérisé en ce que** l'adaptateur embrochable (56) comprend un dispositif d'affichage (60), en particulier un dispositif d'affichage à LCD ou LED, qui est en contact électrique avec le dispositif d'évaluation (20) et est réglé pour afficher la consommation de courant du consommateur connecté (14) au moins sur demande par appui sur une touche d'affichage (62).

10. Dispositif de mesure de courant selon la revendication 8 ou 9, **caractérisé en ce que** l'adaptateur embrochable (56) comprend au moins un dispositif de connexion (64) en contact électrique avec le dispositif d'évaluation (20) et/ou de communication (22) pour connecter d'autres dispositifs, en particulier un dispositif d'affichage externe, un dispositif radio pour augmenter la portée d'émetteur du dispositif de communication (22), un dispositif d'arrêt ou d'alerte pour mettre hors service le consommateur (14) en cas d'augmentation de la consommation de courant, ou dispositifs similaires.

11. Système de mesure d'énergie consommée (70) comprenant au moins un dispositif de mesure de courant (10) selon l'une des revendications précédentes et au moins un dispositif d'évaluation d'énergie consommée (24), en particulier un compteur intelligent (72) et/ou un dispositif d'évaluation décentralisé (74) qui comprend un dispositif de communication pour la réception sans fil d'au moins une valeur de courant mesurée par le dispositif de mesure de courant (10), sachant que le dispositif d'évaluation d'énergie consommée (24) est prévu pour recevoir dans la portée de réception des valeurs de courant d'au moins un, en particulier de tous les dispositifs de mesure de courant (10), et pour évaluer et afficher l'énergie consommée à partir desdites valeurs.

12. Système de mesure d'énergie consommée selon la revendication 11, **caractérisé en ce qu'**un dispositif de mesure de tension d'un compteur intelligent (72) communique avec le dispositif d'évaluation d'énergie consommée (24) afin de déterminer l'énergie consommée, et/ou que le dispositif de mesure de courant (10) transmet au dispositif d'évaluation d'énergie consommée (24) une valeur de courant périodiquement ou en cas de modification du courant consommé.

13. Système de mesure d'énergie consommée selon la revendication 11 ou 12, **caractérisé en ce que** le dispositif d'évaluation d'énergie consommée (24) est connecté à un réseau (76), de préférence sur Internet, via un protocole de réseau, de préférence TCP/IP, sachant que le dispositif d'évaluation d'énergie consommée (24) peut transmettre les valeurs d'énergie consommée mesurées sous forme de données accessibles par le réseau, de préférence des données XML, à au moins un dispositif de mémorisation dans le réseau (78), de préférence une application web, l'accès aux valeurs d'énergie consommée pouvant être accordé à un client du réseau de distribution ou à un gestionnaire du réseau de distribution (80) via le réseau (76), en particulier via un site web.
